(19) Europäisches Patentamt
European Patent Office
Office européen des brevets

(11) **EP 4 651 374 A1**

(12) **EUROPEAN PATENT APPLICATION**

(43) Date of publication:
**19.11.2025 Bulletin 2025/47**

(21) Application number: **25175495.8**

(22) Date of filing: **09.05.2025**

(51) International Patent Classification (IPC):
**H03F 1/02** (2006.01)  **H03F 1/56** (2006.01)
**H03F 3/195** (2006.01)  **H03F 3/24** (2006.01)

(52) Cooperative Patent Classification (CPC):
**H03F 1/0288; H03F 1/565; H03F 3/195;**
**H03F 3/245;** H03F 2200/387; H03F 2200/391;
H03F 2200/417; H03F 2200/421; H03F 2200/451;
H03F 2200/543

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **17.05.2024 US 202418666864**

(71) Applicant: **NXP USA, Inc.**
**Austin, TX 78735 (US)**

(72) Inventor: **STAUDINGER, Joseph**
**5656AG Eindhoven (NL)**

(74) Representative: **Hardingham, Christopher Mark**
**NXP Semiconductors**
**Intellectual Property Group**
**The Cattle Barn**
**Upper Ashfield Farm, Hoe Lane**
**Romsey, Hampshire S051 9NJ (GB)**

(54) **DOHERTY POWER AMPLIFIERS WITH RECONFIGURABLE OUTPUT CIRCUITS**

(57)     A Doherty power amplifier includes a first amplifier (331) with a first output capacitance (333), a second amplifier (351) with a second output capacitance (353), a reconfigurable impedance inverter, and a variable output impedance transformer (380). The reconfigurable impedance inverter includes a combining node (370) and first (334), second (340), and third (354) variable networks. The first variable network (334) and the first amplifier output capacitance (333) establish a first amplifier effective output capacitance that is less than the first output capacitance (333). The second variable network (340) provides a series inductance between the first amplifier output (332) and the combining node (370). The third variable network (354) and the second amplifier output capacitance (353) establish a second amplifier effective output capacitance that is less than the second output capacitance (353). The output impedance transformer (380) includes a fourth variable network (383, 384) that establishes a combining node impedance.

FIG. 3

**EP 4 651 374 A1**

**Description**

TECHNICAL FIELD

Embodiments of the subject matter described herein generally relate to Doherty power amplifiers.

BACKGROUND

For many years, the Doherty power amplifier has been one of the most popular amplifiers for cellular infrastructure applications, given its ability to provide efficient and linear amplification of high peak-to-average power ratio (PAPR) signals. A well-designed, conventional Doherty power amplifier exhibits linear signal amplification across a range of average output power levels, with high efficiency amplification being achievable in the high power region of operation.

A conventional two-way Doherty power amplifier is configured so that operational efficiency is inherently high at $P_{SAT}$, and a backed-off efficiency peak occurs at $P_{BO}$, where $P_{SAT}$ and $P_{BO}$ are essentially fixed power levels. Linear and highly-efficient amplification is achievable at average output power levels in a range from just below $P_{BO}$ up to $P_{SAT}$. However, only the carrier amplifier is active in the low power region of operation (i.e., below $P_{BO}$) and amplifier efficiency decreases rapidly the farther the average output power level decreases below $P_{BO}$. This low power region is characterized by low power efficiency because the load modulation associated with amplifier operation in the high power region does not hold in the low power region. Accordingly, when operating at reduced average output power levels that are significantly below $P_{BO}$, the operational efficiency of a conventional Doherty power amplifier is relatively low.

High-efficiency operation over a wide range of average output power levels is a desirable quality of a Doherty power amplifier. Accordingly, what are needed are Doherty power amplifiers that exhibit high-efficiency performance in the high power region of operation, while also exhibiting high-efficiency performance at significantly reduced average output power levels.

BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.

FIG. 1 is a simplified block diagram of an example communication apparatus in which an embodiment of a reconfigurable Doherty power amplifier may be incorporated;

FIG. 2 is a graph illustrating theoretical efficiency performance as a function of various output power levels for an embodiment of a reconfigurable Doherty power amplifier;

FIG. 3 is a schematic drawing of a reconfigurable Doherty power amplifier, in accordance with an example embodiment;

FIG. 4 is a schematic drawing of a reconfigurable Doherty power amplifier, in accordance with another example embodiment;

FIG. 5 is a schematic drawing of a reconfigurable Doherty power amplifier, in accordance with yet another example embodiment; and

FIG. 6 is a flowchart of a method of operating a reconfigurable Doherty power amplifier, in accordance with an example embodiment.

DETAILED DESCRIPTION

A Doherty power amplifier includes, among other things, an amplifier input terminal, a power splitter, a carrier amplifier, a peaking amplifier, an output circuit with a combining node and an output impedance transformer, and an amplifier output terminal. Embodiments of the inventive subject matter specifically include "reconfigurable" Doherty power amplifiers with "reconfigurable" output circuits coupled between output terminals (e.g., intrinsic drain terminals) of the carrier and peaking amplifiers and the amplifier output terminal. The reconfigurability of the output circuit enables the correct and proper impedances to be established at the carrier and peaking output terminals for a wide range of average output power levels, thus enabling optimal signal amplification and combining to be achievable at full and reduced average output power levels.

As used herein, the term "reconfigurable", in the context of an output circuit, means that the states (e.g., electrical characteristics and/or values) of components, nodes and/or sub-circuits within the output circuit may be selectively changed during operation. According to one or more embodiments, output circuit reconfigurability may be implemented for *N* discrete states ($N \geq 2$), resulting in enhanced Doherty efficiency operation at *N* power back-off levels. Accordingly, the reconfigurable Doherty power amplifier embodiments described herein may exhibit high-efficiency operation at full average output power levels (e.g., output power levels in a high power region between a full saturation output power, $P_{SAT-F}$, and a corresponding full backed-off output power, $P_{BO-F}$), while also exhibiting high-efficiency operation at significantly reduced average output power levels (e.g., output power levels below the full backed-off output power, $P_{BO-F}$).

As will be described in detail later, embodiments of Doherty power amplifiers described herein are capable of being dynamically reconfigured into different amplifier states. In various embodiments, the Doherty amplifier is electronically controlled into different amplifier states based on the actual or anticipated traffic loading (e.g., based on how many users are or are anticipated to be communicating on the system). For example, when the communication apparatus that includes the reconfigurable Doherty power amplifier is (or is anticipated to be) processing high levels of traffic (e.g., between 75% and 100% traffic loading), the system may determine that the reconfigurable Doherty power amplifier should be configured (or reconfigured) into a "full power state" in which the amplifier should operate efficiently at full average output power levels. Conversely, when the amplifier system is (or is anticipated to be) processing lower levels of traffic (e.g., below 75% traffic loading), the system may determine that the reconfigurable Doherty power amplifier should be configured (or reconfigured) into a "backoff power state" (or into one of a plurality of different backoff power states) in which the amplifier should operate efficiently at reduced average output power levels. Either way, the system may produce control signals that cause the reconfigurable Doherty power amplifier to be reconfigured into the full power state or into a backoff power state. In other words, according to some embodiments, traffic tracking may be performed on the traffic being processed by the amplifier system, and the selected amplifier state may be determined based on the instantaneously-measured traffic loading. In other embodiments, the relative traffic loading during various time ranges may be anticipated (rather than instantaneously measured), and the amplifier state may be selected based on temporal information (e.g., the current time of day, the current day of the week, or based on some other temporal information). In still other embodiments, the amplifier state may be selected based on other factors.

It should be noted here that various embodiments described herein provide for reconfigurability of Doherty amplifiers based on actual or anticipated system traffic or traffic loading. These "traffic tracking" techniques are different from "envelope tracking" techniques in which operation of an amplifier may be modified based on the instantaneous amplitude of a signal that is to be amplified by the system (e.g., a signal with high PAPR). Envelope tracking techniques may include, for example, high-speed (e.g., on the order of nanoseconds) adjustments to transistor bias voltages based on the instantaneous signal amplitude. In contrast, the traffic tracking techniques discussed herein involve reconfiguring an amplifier output circuit into different amplifier states based on actual or anticipated traffic loading, where each amplifier state corresponds to a different set of component and impedance values. Using these traffic tracking techniques, transitions between amplifier states may be performed less frequently than envelope tracking bias adjustments. For example, as will be described in more detail later, some embodiments of traffic tracking based circuit reconfigurations may be made in response to dynamic traffic loading measurements that are taken milliseconds apart or longer. Other embodiments of traffic tracking based circuit reconfigurations may be made in response to anticipated traffic loading during pre-determined time ranges (e.g., from midnight to 5 am, from 5 am to 9 am, from 9 am to 6 pm, and from 6 pm to midnight), and/or based on anticipated traffic loading on particular days (e.g., Monday-Friday or weekend days). Although envelope tracking techniques may be used in addition to the traffic tracking techniques described herein, the inventive subject matter of the present embodiments includes using traffic tracking techniques.

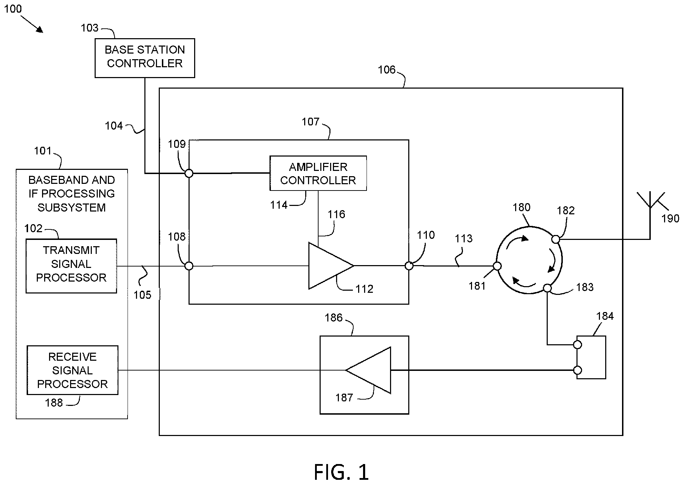

To provide context, FIG. 1 is a simplified block diagram of an example communication apparatus 100 in which an embodiment of a reconfigurable Doherty power amplifier (e.g., amplifier 112) may be incorporated. For example, the communication apparatus 100 may be implemented in a base station (not illustrated) of a cellular communication system (or in another apparatus associated with a cellular or other type of communication system). Communication apparatus 100 includes a baseband and intermediate frequency (IF) processing subsystem 101, a base station controller 103, a radio frequency (RF) transceiver 106, and an antenna 190.

The base station controller 103 includes hardware and associated software that is generally responsible for controlling the operations of the communication apparatus 100, including managing radio channels (e.g., allocating channels and optimizing the utilization of available resources), performing mobile device handovers, and performing call setups, among other things.

According to one or more embodiments, the base station controller 103 may perform traffic loading measurements (traffic tracking) on a periodic or continuous basis, and may provide control signals 104 to the RF transceiver 106 based on the traffic loading measurements. Based on the control signals 104 from the base station controller 103, the RF transceiver 106 (and more specifically, the amplifier controller 114) may reconfigure the output circuit of the amplifier 112 into one of *N* amplifier states ($N \geq 2$), as will be discussed in more detail later. The examples provided below assume that the number of amplifier states, *N*, is equal to 4. One of skill in the art would understand, based on the description herein, that the number of amplifier states, *N*, may be different (e.g., *N* = 2, *N* = 3, or *N* > 4).

According to one or more embodiments, the base station controller 103 may maintain a look up table (*see* Table 1, below), which correlates traffic loading ranges to power levels (and/or amplifier states). The number of discrete power levels and the number of traffic loading ranges may equal the number of amplifier states, N.

With reference to Table 1, below, the base station controller 103 may periodically or continuously measure or determine the instantaneous traffic loading condition of the system, and may compare the instantaneous traffic loading conditions to one or more thresholds to determine in which of N traffic loading ranges the instantaneous traffic loading condition falls (first column of Table 1). Each of the traffic loading ranges may correspond to one of N power levels and/or amplifier states (second column of Table 1). The base station controller 103 may then provide a control signal (e.g., control signal 104) to the transmitter 107 that indicates the power level and/or amplifier state corresponding to the current traffic loading. As will be described in detail below, the transmitter 107 then configures (or reconfigures) the amplifier (e.g., amplifier 112) in response to the control signal.

Table 1 - Traffic loading versus amplifier state table

| TRAFFIC LOADING RANGE | POWER LEVEL (AMPLIFIER STATE) |
|---|---|
| 75% - 100% | FULL POWER (STATE 1) |
| 50% - 75% | FIRST BACKOFF POWER (STATE 2) |
| 25% - 50% | SECOND BACKOFF POWER (STATE 3) |
| 0% - 25% | THIRD BACKOFF POWER (STATE 4) |

According to one or more other example embodiments, the base station controller 103 may maintain a look up table (see Table 2, below), which correlates time-of-day ranges to power levels (and/or amplifier states). The number of discrete power levels and the number of time-of-day ranges may equal the number of amplifier states, N.

With reference to Table 2, below, the base station controller 103 may determine in which of N time-of-day ranges the current time of day falls (first column of Table 2). Each of the time-of-day ranges may correspond to one of N power levels and/or amplifier states (second column of Table 2). The base station controller 103 may then provide a control signal (e.g., control signal 104) to the transmitter 107 that indicates the power level and/or amplifier state corresponding to the current time of day. As will be described in detail below, the transmitter 107 then configures (or reconfigures) the amplifier (e.g., amplifier 112) in response to the control signal.

Table 2 - Time-of-day versus amplifier state table

| TIME-OF-DAY RANGE | POWER LEVEL (AMPLIFIER STATE) |
|---|---|
| 9 AM TO 6 PM | FULL POWER (STATE 1) |
| 6 PM TO MIDNIGHT | FIRST BACKOFF POWER (STATE 2) |
| 5 AM TO 9 AM | SECOND BACKOFF POWER (STATE 3) |
| MIDNIGHT TO 5 AM | THIRD BACKOFF POWER (STATE 4) |

Referring again to FIG. 1, the baseband and IF processing subsystem 101 includes a transmit signal processor 102 and a receive signal processor 188. According to one or more embodiments, the transceiver 106 includes a transmitter 107, a circulator 180, an RF switch 184, and a receiver 186.

In a transmit mode of operation of system 100, the transmit signal processor 102 of the baseband and IF processing subsystem 101 performs baseband and IF processing to produce an RF transmit signal 105. The transmitter 107 receives and amplifies the RF transmit signal 105, and produces an amplified RF transmit signal 113, which ultimately will be transmitted over the air by antenna 190.

According to one or more embodiments, the transmitter 107 includes an RF signal input 108, a control signal input 109, a power amplifier 112, an amplifier controller 114, and an RF signal output 110. Through the RF signal input 108, the power amplifier 112 receives the RF transmit signal 105 from the transmit signal processor 102. According to one or more embodiments, the power amplifier 112 is a relatively high-gain amplifier, which amplifies the RF transmit signal 105, and produces an amplified RF transmit signal 113 at the RF signal output 110.

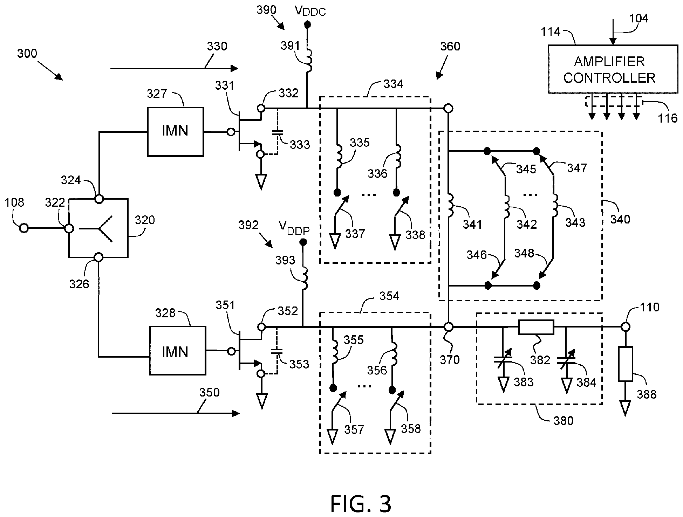

According to various embodiments, the power amplifier 112 may be a reconfigurable Doherty power amplifier (e.g., amplifier 300, 400, 500, FIGs 3-5) with a reconfigurable output circuit (e.g., output circuit 360, 460, 560, FIGs 3-5). As will be described in detail later, the configuration of the reconfigurable output circuit is established based on the control signals 104 received from the base station controller 103. As indicated above, the control signals 104 may indicate a power level (e.g., full power, first backoff power, etc.) and/or an amplifier state (e.g., state 1, state 2, etc.). According to one or more embodiments, the amplifier controller 114 receives the control signals 104 from the base station controller 103 through the control signal input 109 (e.g., a serial-peripheral input (SPI) port, or another suitable control signal interface). Based on the control signals 104, the amplifier controller 114 may determine and provide additional control signals (e.g., switch control signals over switch control lines 116, FIGs 1, 3-5) to the power amplifier 112, which may cause the power amplifier 112 to reconfigure its output circuit (e.g., output circuit 360, 460, 560, FIGs 3-5). As will be described in more detail later, the reconfigurable output circuit of the power amplifier 112, enables the power amplifier 112 to amplify the RF transmit signal 105 in a linear and efficient manner over a wide range of average power levels and traffic loading conditions.

The amplified RF transmit signal 113 produced at the RF output 110 of transmitter 107 is conveyed to circulator 180. Circulator 180 includes a transmitter port 181, an antenna port 182, and a receiver port 183. The amplified RF transmit signal 113 is received at the transmitter port 181 of circulator 180. The circulator 180 may thereafter convey the amplified RF transmit signal 113 to the antenna port 182, which is coupled to antenna 190. Antenna 180 is configured to radiate the amplified RF transmit signal 113 over the air interface.

The circulator 180 is characterized by a signal-conduction directivity, which is indicated by the arrows within the depiction of circulator 180. Essentially, RF signals may be conveyed between the circulator ports 181-183 in the indicated direction (counter-clockwise), and not in the opposite direction (clockwise). Accordingly, during normal operations, signals may be conveyed through the circulator 180 from transmitter port 181 to antenna port 182, and from antenna port 182 to receiver port 183, but not directly from transmitter port 181 to receiver port 183 or from receiver port 183 to antenna port 182.

In a receive mode of operation, antenna 190 may receive RF signals over the air interface, and may provide the RF receive signals to the antenna port 182 of the circulator 180. The circulator 180 may then convey the RF receive signals to the receiver port 183 of the circulator 180. The receiver port 183 of circulator 180 may be coupled through the RF switch 184 to the receiver 186. The receiver 186 includes a receive amplifier 187 (e.g., a low noise amplifier), which amplifies the RF receive signals, and provides amplified RF receive signals to the receive signal processor 188 of the baseband and IF processing subsystem 101.

The RF switch 184 is optional, but is desirably included in order to ensure good isolation for the receiver 186. Particularly, in some situations, while the transceiver 106 is in the transmit mode of operation, the circulator 180 may not be able to convey signal energy received through the transmitter port 181 to the antenna 190 through antenna port 182. For example, the antenna 190 may be disconnected from the antenna port 182, or may otherwise be in a very high impedance state. In such situations, the circulator 180 may convey signal energy from the transmitter 107 (i.e., signal energy received through transmitter port 181) past the antenna port 182 to the receiver port 183. To avoid conveying transmitter signal energy into the receiver 186 while the transceiver 106 is in the transmit mode, the RF switch 184 may be operated as a failsafe switch, which couples any transmitter signal energy to a ground reference node (not shown) while the transceiver 106 is in the transmit mode.

The configuration of the communication apparatus 100 shown in FIG. 1 is provided for context and example purposes. In other embodiments, the circulator 180 may be excluded, and an RF switch instead may be used to establish signal paths between the antenna 190 and either the transmitter 107 or the receiver 186 in a half-duplex manner. Other modifications also may be made to communication apparatus 100, as well.

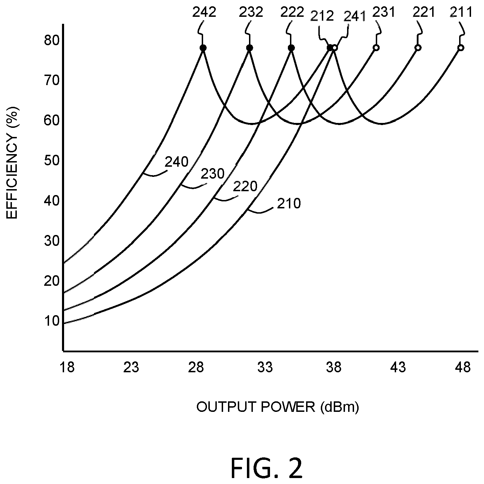

To better explain how the power amplifier 112 may be reconfigured to provide linear and efficient amplification over a wide range of average output power levels, reference is now made to FIG. 2, which is a graph 200 illustrating a plurality of power efficiency curves 210, 220, 230, 240, with each curve being associated with one of a plurality of amplifier states for an embodiment of a reconfigurable Doherty power amplifier. More specifically, power efficiency curve 210 is associated with a first amplifier state (state 1) corresponding to full average output power, power efficiency curve 220 is associated with a second amplifier state (state 2) corresponding to a first backoff power, power efficiency curve 230 is associated with a third amplifier state (state 3) corresponding to a second backoff power, and power efficiency curve 240 is associated with a fourth amplifier state (state 4) corresponding to a third backoff power.

The horizontal axis of graph 200 corresponds to output power (in dBm), and the vertical axis of graph 200 corresponds to drain efficiency (in percent). Again, the example assumes that the number of amplifier states, $N$, is equal to 4, and accordingly, graph 200 includes 4 power efficiency curves 210, 220, 230, 240. One of skill in the art would understand, based on the description herein, that the number of amplifier states, $N$, may be different (e.g., $N = 2$, $N = 3$, or $N > 4$), and correspondingly, a different number of power efficiency curves may be supported by the system.

In the vernacular of Doherty power amplifiers, which will be used herein, "saturation output power", $P_{SAT}$, refers to the output power level at which the Doherty amplifier enters saturation, and "backed-off output power", $P_{BO}$, refers to a lower output power level along the same power efficiency curve at which a peaking amplifier of the Doherty power amplifier begins conducting (e.g., typically from about 6 dBm to about 10 dBm below $P_{SAT}$). Each amplifier state causes the reconfigurable Doherty power amplifier efficiency to be characterized by a different saturation output power, $P_{SAT}$, and a different backed-off output power level, $P_{BO}$. Accordingly, each power efficiency curve 210, 220, 230, 240 is characterized by a different saturation output power, $P_{SAT}$, and a different backed-off output power level, $P_{BO}$.

As used herein, "full" saturation output power, $P_{SAT-F}$, means a theoretically highest saturation output power, which is associated with an embodiment of a reconfigurable Doherty power amplifier that is configured in a "full output power" state. Similarly, as used herein, "full" backed-off output power, $P_{BO-F}$, means a power level at which a first efficiency peak occurs below $P_{SAT-F}$ while the amplifier is in the "full power" state (e.g., at about 6 dBm to about 10 dBm below the full saturation output power, $P_{SAT-F}$).

Conversely, "reduced" saturation output power, $P_{SAT-R}$, means a saturation power below the full saturation output power, and associated with an embodiment of a Doherty power amplifier that is in a "reduced output power" state. Accordingly, "reduced" backed-off output power, $P_{BO-R}$, means a power level at which a first efficiency peak occurs below $P_{SAT-R}$ while the amplifier is in the "reduced output power" state.

Embodiments of reconfigurable Doherty power amplifiers discussed herein are configured to support a full output power state (corresponding to $P_{SAT-F}$ and $P_{BO-F}$) and one or more reduced output power states. In such embodiments, a specific reduced output power state may be indicated with $P_{SAT-R}$ and $P_{BO-R}$ with a number in the suffix. For example, the saturation output power and the backed-off output power for a first reduced output power state may be designated as $P_{SAT-R1}$ and $P_{BO-R1}$, the saturation output power and the backed-off output power for a second (lower) reduced output power state may be designated as $P_{SAT-R2}$ and $P_{BO-R2}$, the saturation output power and the backed-off output power for a third (even lower) reduced output power state may be designated as $P_{SAT-R3}$ and $P_{BO-R3}$, and so on. Other embodiments of reconfigurable Doherty power amplifiers may be configured to support only two amplifier states (i.e., $N = 2$), including a full output power state (corresponding to $P_{SAT-F}$ and $P_{BO-F}$) and only one reduced output power state (corresponding to $P_{SAT-R}$ and $P_{BO-R}$).

Referring to FIG. 2, power efficiency curve 210 corresponds to the full output power state (e.g., state 1). As indicated by curve 210, when an embodiment of a reconfigurable Doherty amplifier is in the full output power state, the full saturation output power, $P_{SAT-F}$, is about 47 dBm, as indicated by circle 211, and the full backed-off output power, $P_{BO-F}$, is about 37 dBm, as indicated by dot 212 (e.g., about 10 dBm below the full saturation output power 211, $P_{SAT-F}$). Depending on various characteristics of the reconfigurable Doherty amplifier (e.g., the frequency of operation, circuit topology, and other characteristics), the full saturation output power and the full backed-off output power may have higher or lower values than those given above.

Power efficiency curve 220 corresponds to a first reduced output power state (e.g., state 2). As indicated by curve 220, when an embodiment of a reconfigurable Doherty amplifier is in the first reduced output power state, the reduced saturation output power, $P_{SAT-R1}$, is about 45 dBm, as indicated by circle 221 (e.g., about 3.0 dBm below $P_{SAT-F}$ point 211), and the reduced backed-off output power, $P_{BO-R1}$, is about 35 dBm, as indicated by dot 222 (e.g., about 10 dBm below the reduced saturation output power 221, $P_{SAT-R1}$). Again, depending on various characteristics of the reconfigurable Doherty amplifier, the first reduced saturation output power and the first reduced backed-off output power may have higher or lower values than those given above.

Power efficiency curve 230 corresponds to a second and further reduced output power state (e.g., state 3). As indicated by curve 230, when an embodiment of a reconfigurable Doherty amplifier is in the second reduced output power state, the reduced saturation output power, $P_{SAT-R2}$, is about 42 dBm, as indicated by circle 231 (e.g., about 6.0 dBm below $P_{SAT-F}$ point 211), and the second reduced backed-off output power, $P_{BO-R2}$, is about 32 dBm, as indicated by dot 232 (e.g., about 10 dBm below the second reduced saturation output power 231, $P_{SAT-R2}$). Again, depending on various characteristics of the reconfigurable Doherty amplifier, the second reduced saturation output power and the second reduced backed-off output power may have higher or lower values than those given above.

Finally, power efficiency curve 240 corresponds to a third and even further reduced output power state (e.g., state 4). As indicated by curve 240, when an embodiment of a reconfigurable Doherty amplifier is in the third reduced output power state, the reduced saturation output power, $P_{SAT-R3}$, is about 38 dBm, as indicated by circle 241 (e.g., about 10.0 dBm below $P_{SAT-F}$ point 211), and the third reduced backed-off output power, $P_{BO-R3}$, is about 28 dBm, as indicated by dot 242 (e.g., about 10 dBm below the third reduced saturation output power 241, $P_{SAT-R3}$). Again, depending on various characteristics of the reconfigurable Doherty amplifier, the third reduced saturation output power and the third reduced backed-off output power may have higher or lower values than those given above. Further, the reconfigurable Doherty amplifier may have more or fewer than three reduced output power states.

During operation of an embodiment of a reconfigurable Doherty power amplifier, an amplifier state (e.g., a full output power state) that has a power efficiency curve characterized by a relatively high $P_{SAT}$ and a relatively high corresponding $P_{BO}$ (e.g., curve 210) may be selected for higher traffic loading conditions in order to support amplification at high average output power levels. Conversely, an amplifier state (e.g., a reduced output power state) that has a power efficiency curve characterized by a relatively low $P_{SAT}$ and a relatively low corresponding $P_{BO}$ (e.g., one of curves 220, 230, 240) may be selected for lower traffic loading conditions in order to support amplification at lower average output power levels. The ability to reconfigure a Doherty power amplifier to operate with a reduced $P_{SAT}$ and a reduced corresponding $P_{BO}$ has the potential advantage of enabling efficient processing of signals with lower average output power levels (e.g., while traffic loading is relatively low), thus yielding overall power savings.

Embodiments of reconfigurable Doherty power amplifiers described herein include reconfigurable output circuits (e.g., output circuits 360, 460, 560, FIGs 3-5). Each reconfigurable output circuit includes a combining node (e.g., combining node 370, FIGs 3-5), reconfigurable carrier output circuits (e.g., circuits 334, 340, 440, 540, FIGs 3-5) coupled between the carrier amplifier intrinsic drain terminal and the combining node, and a reconfigurable peaking output circuit (e.g., circuit 354, FIGs 3-5) coupled between the peaking amplifier intrinsic drain terminal and the combining node. Further, each reconfigurable Doherty power amplifier includes a reconfigurable output impedance transformer (e.g., transformer 380, FIGs 3-5) coupled between the combining node and the amplifier output terminal (e.g., RF output 110, FIGs 3-5).

As used herein, "reconfigurable" means that various elements in the output circuit embodiments may be controlled (e.g., enabled or disabled) to configure the Doherty power amplifier into any of $N$ amplifier states, where $N \geq 2$ ($N$ is greater than or equal to 2). Each amplifier state may be structured so that the amplifier achieves peak efficiencies (e.g., efficiencies of 70% or more) at one of multiple backed-off output power levels, $P_{BO-F}$, $P_{BO-R1}$, $P_{BO-R2}$, and so on.

For example, some embodiments reconfigurable Doherty power amplifiers include a reconfigurable output circuit that is able to be selectively configured into either of two amplifier states (i.e., $N = 2$), with a first amplifier state being desirably selected for full average output power (e.g., 39.5 dBm or some other value), and a second amplifier state being desirably selected for a single reduced average output power level (e.g., 38.0 dBm or some other value). As another example, some embodiments of reconfigurable Doherty power amplifiers include a reconfigurable output circuit that is able to be selectively configured into any of four amplifier states (i.e., $N = 4$), with a first amplifier state being desirably selected for full average output power (e.g., 39.5 dBm or some other value), a second amplifier state being desirably selected for a first reduced average output power level (e.g., 38.0 dBm or some other value), a third amplifier state being desirably selected for a second and further reduced average output power level (e.g., 36.5 dBm or some other value), and a fourth amplifier state being desirably selected for a third and even further reduced average output power level (e.g., 29.5 dBm or some other value). In still other example embodiments, the number of amplifier states, $N$, into which embodiments of a reconfigurable output circuit may be selectively configured may be higher than 4 (e.g., up to or exceeding 16 amplifier states), thus enabling the reconfigurable Doherty power amplifier to be configured for high efficiency operation at even more than three different reduced average output power levels.

In various embodiments, a reconfigurable output circuit (e.g., output circuits 360, 460, 560, FIGs 3-5) of a Doherty power amplifier (e.g., amplifiers 300, 400, 500, FIGs 3-5) may be selectively configured to modify the effective values of drain-source capacitances, $C_{EFF\_C}$ and $C_{EFF\_P}$, for the carrier and peaking amplifiers, respectively. Embodiments of a reconfigurable output circuit of a Doherty power amplifier also may be selectively configured to reconfigure the variable circuit that couples the carrier amplifier intrinsic drain terminal to the combining node. Further, embodiments of a reconfigurable output circuit of a Doherty power amplifier also may be configured to modify the impedance at the combining node by reconfiguring the output impedance transformer circuit, which couples the combining node to the amplifier output terminal.

For purposes of illustration only, and not by way of limitation, example Doherty power amplifier embodiments discussed in detail below have a 2:1 asymmetry ratio, and include reconfigurable 0 degree/90 degree (0/90) output combiner structures (i.e., approximately 0 degrees of electrical length couples the peaking amplifier intrinsic drain terminal and the combining node, and approximately 90 degrees of electrical length couples the carrier amplifier intrinsic drain terminal and the combining node). With a 2:1 asymmetry ratio, the size and power handling capability of the peaking amplifier, $P_{peaking}$, is about twice the size and power handling capability of the carrier amplifier, $P_{carrier}$. Other embodiments may include reconfigurable output combiner structures implemented in symmetric Doherty power amplifiers, or in asymmetric Doherty power amplifiers with different asymmetry ratios. Further, other embodiments may include reconfigurable output combiner structures with different electrical lengths between the carrier and peaking intrinsic drain terminals and the combining node (e.g., 90/180, 180/270, and so on). Further still, the Doherty amplifier embodiments discussed herein correspond to "noninverted" configurations in which the peaking input RF signal (at the input to the peaking amplifier 351) is delayed by about 90 degrees from the carrier input RF signal (at the input to the carrier amplifier 331) in order to compensate for about 90 degrees of phase delay that is applied to the amplified carrier output RF signal between the carrier amplifier output 332 and the combining node 370. Alternate embodiments may include "inverted" Doherty amplifier configurations in which the carrier input RF signal (at the input to the carrier amplifier 331) is delayed by about 90 degrees from the peaking input RF signal (at the input to the peaking amplifier 351) in order to compensate for about 90 degrees of phase delay that is applied to the amplified peaking output RF signal between the peaking amplifier output 352 and the combining node 370. In the inverted Doherty amplifier configuration, the second variable network (e.g., networks 340, 440, 540, FIGs 3-5) would be present between the peaking amplifier output 352 and the combining node 370, rather than between the carrier amplifier output 332 and the combining node 370.

Example component values that are provided below correspond to a 2:1 asymmetric Doherty power amplifier with a full saturation output power, $P_{SAT-F}$, of about 48 dBm, a full average output power level of about 39.5 dBm, and a first efficiency peak at a full backed-off output power, $P_{BO-F}$, of about 38.5 dBm (i.e., about 9.5 dB below $P_{SAT-F}$). It should be understood that embodiments of Doherty power amplifiers may be designed with different asymmetry ratios (including symmetric Doherty power amplifiers), different full saturation output powers, different full average output power levels, and/or efficiency peaks at different full backed-off output powers, and such Doherty amplifier embodiments may have different component values than the example component values provided herein.

In addition, although embodiments of asymmetric Doherty power amplifiers are described in detail herein, it should be understood that other embodiments of reconfigurable Doherty power amplifiers may have a symmetric configuration (e.g., the relative sizes and power handling capabilities of the carrier and peaking amplifiers are equal). As used herein, the term "size", when referring to a physical characteristic of a power amplifier or power transistor, refers to the periphery or the power handling capability of the transistor(s) associated with that amplifier or transistor. The term "symmetric", when referring to the relative sizes and power handling capabilities of carrier and peaking amplifiers, means that the cumulative size of the power transistor(s) forming the carrier amplifier is/are substantially identical to (i.e., within 5%) the cumulative size of the power transistor(s) forming the peaking amplifier. Conversely, the term "asymmetric" means that the cumulative size of the power transistor(s) forming the peaking amplifier is from 25% greater to 200% greater (e.g., 100% greater) than the cumulative size of the power transistor(s) forming the carrier amplifier. Accordingly, for example, when the ratio of peaking amplifier size to carrier amplifier size (or the "peaking-to-carrier ratio") is denoted as $x{:}y$ (where $x$ corresponds to relative peaking amplifier size and $y$ corresponds to relative carrier amplifier size), a ratio of 1:1 corresponds to a symmetric amplifier, and a ratio of 2:1 corresponds to an asymmetric amplifier, according to the above definitions. Further, as used herein, the term "shunt" means electrically coupled between a circuit node and a ground reference (or other DC voltage reference).

Additional details will now be provided for embodiments of reconfigurable Doherty power amplifiers (e.g., amplifier 112, FIG. 1) that are able to be dynamically configured into different states to achieve multiple power efficiency curves (e.g., power efficiency curves 210, 220, 230, 240, FIG. 2).

FIG. 3 is a schematic drawing of a reconfigurable Doherty power amplifier 300 with a reconfigurable output circuit 360 that is capable of being selectively configured into any of $N$ impedance states, in accordance with an example embodiment. As will be discussed in more detail below, each state is associated with a different average output power level. For context, the reconfigurable Doherty power amplifier 300 may be used in a power amplifier (e.g., amplifier 112, FIG. 1) in RF circuitry of a communication system.

Doherty amplifier 300 includes an RF input 108, an RF output 110, power splitter 320, a carrier amplification path 330 with a carrier amplifier 331, a peaking amplification path 350 with a peaking amplifier 351, a reconfigurable output circuit 360 (or "reconfigurable impedance inverter") with a combining node 370, and a reconfigurable output impedance transformer 380. In an embodiment, an antenna 388 (or other type of load) is coupled to the RF output 110 (e.g., through a circulator (e.g., circulator 180, FIG. 1), an RF switch, or other circuitry). Although not shown, a DC blocking capacitor also may be coupled between the combining node 370 and the RF output 110.

Doherty power amplifier 300 is considered to be a "two-way" Doherty power amplifier, which includes one carrier amplification path 330 and one peaking amplification path 350. Essentially, the carrier amplifier 331 provides RF signal amplification along the carrier amplification path 330, and the peaking amplifier 351 provides RF signal amplification along the peaking amplification path 350. The amplified carrier and peaking RF signals are then conveyed through the reconfigurable output circuit 360 and combined at combining node 370 before provision through the reconfigurable output impedance transformer 380 to the RF output 110.

The power splitter 320 is configured to receive, at power splitter input 322, an input RF signal from RF input 108. The power splitter 320 is further configured to divide the power of the input RF signal into a carrier input signal RF and a peaking input RF signal, which are produced at power splitter outputs 324, 326, respectively. In this manner, the power splitter 320 is configured to provide the carrier input RF signal to the carrier amplification path 330, and to provide the peaking input RF signal to the peaking amplification path 350. According to an embodiment, the power splitter 320 is configured to produce the carrier and peaking input RF signals with a desired phase difference (typically about 90 degrees) between the carrier and peaking input RF signals.

Power splitter 320 may have any of a variety of configurations, including Wilkinson-type splitters, hybrid quadrature splitters, and so on. Power splitter 320 divides the power of the input RF signal according to a carrier-to-peaking size ratio. For example, when Doherty amplifier 300 has a symmetric Doherty amplifier configuration in which the carrier amplifier 331 and the peaking amplifier 351 are substantially equal in size, the power splitter 320 may divide the power such that about half of the input signal power is provided to the carrier amplification path 330, and about half of the input signal power is provided to the peaking amplification path 350. Conversely, when Doherty amplifier 300 has an asymmetric Doherty amplifier configuration, the power splitter 320 may divide the power unequally. For example, when the Doherty amplifier 300 has a 2:1 peaking-to-carrier size ratio such, the power splitter 320 may divide the input signal power so that approximately one third of the input signal power is provided to the carrier amplification path 330, and approximately two-thirds of the input signal power is provided to the peaking amplification path 350. In Doherty amplifier 300, the power splitter 320 is configured so that, at the center frequency of operation, $f0$, of the amplifier 300, the input signal supplied to the peaking amplification path 350 is delayed by an input phase offset (e.g., about 90 degrees) with respect to the input signal supplied to the carrier amplification path 330.

The carrier amplification path 330 includes a carrier input matching network (IMN) 327, the carrier amplifier 331, and first and second variable networks 334, 340, according to one or more embodiments. Similarly, the peaking amplification path 350 includes a peaking IMN 328, the peaking amplifier 351, and a third variable network 354. It may be noted here that the term "network," as used herein, is analogous to "circuit", "electronic circuit", and "circuitry."

The carrier and peaking IMNs 327, 328 are coupled between the power splitter outputs 324, 326 and the carrier and peaking amplifiers 331, 351, respectively. The carrier and peaking IMNs 327, 328 each may include, for example, lowpass or bandpass circuits configured as T- or pi- impedance matching networks, although other matching network topologies also are anticipated. However they are configured, the IMNs 327, 328 incrementally increase the circuit impedance toward the source impedance.

The carrier and peaking amplifiers 331, 351 each may be implemented as a power transistor (or a series of power transistors). Accordingly, each of the carrier and peaking amplifiers 331, 351 have a control input (e.g., a gate terminal) and two current-carrying terminals (e.g., drain and source terminals). First ones of the current-carrying terminals (e.g., the drain terminals) of the amplifiers 331, 351 function as outputs 332, 352 of the carrier and peaking amplifiers 332, 351, where amplified RF signals are produced by the amplifiers 331, 351. Second ones of the current-carrying terminals (e.g., the source terminals) of the amplifiers 331, 351 may be coupled to a ground reference node.

According to an embodiment, the first current-carrying terminals (e.g., drain terminals) each correspond to an intrinsic current generator (e.g., an intrinsic drain) of each amplifier 331, 351. Capacitances 333, 353 represent parasitic output capacitances (e.g., drain-source capacitances) present at the outputs of the carrier and peaking amplifiers 331, 351 (e.g., at the drain terminals of the carrier and peaking power transistors). In other words, the carrier amplifier output 332 is characterized by a drain-source capacitance 333 (or carrier amplifier output capacitance) between the drain and source terminals of the carrier amplifier 331. Similarly, the peaking amplifier output 352 is characterized by a drain-source capacitance 353 (or peaking amplifier output capacitance) between the drain and source terminals of the peaking amplifier 351. Although capacitances 333, 353 are not discrete physical components (e.g., discrete capacitors), capacitances 333, 353 are depicted in FIG. 3 to facilitate later discussion of how the variable output networks 334, 354 may contribute to effective output capacitances, $C_{EFF\_C}$ and $C_{EFF\_P}$, of the carrier and peaking amplifiers 331, 351. According to an embodiment, parasitic capacitances 333, 353 each have a capacitance value in a range of about 0.25 picofarads (pF) to about 20 pF, although the capacitance values may be lower or higher, as well.

The carrier amplifier 331 and the peaking amplifier 351 each include one or more power transistors (e.g., field effect transistors) embodied in a semiconductor die. In some embodiments, the semiconductor die(s) that include the carrier and peaking amplifiers 331, 351 may be packaged in a power amplifier device or a power amplifier module, along with all or portions of the carrier and peaking IMNs 327, 328 and the first, second, and third variable networks 334, 354, 340.

According to an embodiment, the carrier amplifier 331 and the peaking amplifier 351 each include a single-stage amplifier (i.e., an amplifier with a single amplification stage or power transistor). In other embodiments, the carrier amplifier 331 is a two-stage amplifier, which includes a relatively low-power driver amplifier (not shown) and a relatively high-power final-stage amplifier (not shown) connected in a cascade (or series) arrangement between the carrier amplifier input and the carrier amplifier output. Similarly, the peaking amplifier 351 may include a two-stage amplifier, which includes a relatively low-power driver amplifier (not shown) and a relatively high-power final-stage amplifier (not shown) connected in a cascade arrangement between the peaking amplifier input and the peaking amplifier output.

Although not shown in FIG. 3, various DC bias circuits are coupled to the inputs and to the outputs of the carrier and peaking amplifiers 331, 351, in order to convey DC bias voltages that will ensure proper operation of the Doherty amplifier 300. More specifically, during operation of Doherty amplifier 300, the carrier amplifier 331 is biased to operate in class AB mode or deep class AB mode, and the peaking amplifier 351 is biased to operate in class C mode or deep class C mode. In some configurations, the peaking amplifier 351 may be biased to operate in class B mode.

For example, output DC bias circuits 390, 392 may be coupled to the outputs (e.g., drain terminals) of the carrier and peaking amplifiers 331, 351, respectively, and the output DC bias circuits 390, 392 are configured to convey drain bias voltages, $V_{DDC}$ and $V_{DDP}$, to the outputs (e.g., drain terminals) of the carrier and peaking amplifiers 331, 351, respectively. Each output DC bias circuit 390, 392 may include a bias inductor 391, 393, according to one or more embodiments. The bias inductors 391, 393 may affect the effective output capacitances, $C_{EFF\_C}$ and $C_{EFF\_P}$, of each of the carrier and peaking amplifiers 331, 351. When amplifier 300 is a symmetrical Doherty power amplifier with substantially equal parasitic output capacitances 333, 353, the bias inductors 391, 393 may have substantially equal inductance values. Conversely, when amplifier 300 is an asymmetrical Doherty power amplifier with unequal parasitic output capacitances 333, 353 (e.g., the parasitic output capacitance 353 of the peaking amplifier 351 may be about twice the parasitic output capacitance 353 of the carrier amplifier 331 for a 2:1 Doherty power amplifier), the bias inductors 391, 393 may have unequal inductance values, which cause the effective output capacitances, $C_{EFF\_C}$ and $C_{EFF\_P}$, for the carrier and peaking amplifiers 331, 351, respectively, to be equal (assuming that none of shunt inductors 335, 336, 355, 356 are coupled to ground). To avoid complicating the below description of the various embodiments, it will be assumed that the values of the parasitic output capacitances 333, 353 include the effects of the bias inductors 391, 393.

The carrier amplifier 331 is configured to amplify the carrier input RF signal produced at splitter output 324, and to produce an amplified carrier output RF signal at the carrier amplifier output 332 (e.g., the carrier amplifier intrinsic drain terminal). Similarly, the peaking amplifier 351 is configured to amplify the peaking input RF signal produced at splitter output 326, and to produce an amplified peaking output RF signal at the peaking amplifier output 352 (e.g., the peaking amplifier intrinsic drain terminal).

The carrier and peaking amplifier outputs 332, 352 are coupled through a reconfigurable output circuit 360 and a reconfigurable output impedance transformer 380 to the RF output 110. According to one or more embodiments, the reconfigurable output circuit 360 includes a combining node 370, a first variable network 334 coupled to the carrier amplifier output 332, a second variable network 340 coupled between the carrier amplifier output 332 and the combining node 370, and a third variable network 354 coupled to the peaking amplifier output 352 and to the combining node 370.

The first, second, and third variable networks 334, 340, 354 are configured to function as an impedance inverter. Generally, and as will be described in more detail below, the impedance inverter includes a first shunt capacitance (carrier drain-source capacitance 333 as modified by the first variable network 334), a series inductance (second variable network 340), and a second shunt capacitance (peaking drain-source capacitance 353 as modified by the third variable network 354). In other words, the circuit formed by variable networks 334, 340, and 354 is a PI network consisting of a shunt C (variable network 334), a series L (network 340), and a shunt C (network 354). Theoretically, the best performance of amplifier 300 (e.g., optimal bandwidth) may be achieved when the capacitance values of the first and last C are substantially equal (i.e., $C_{EFF\_C} = C_{EFF\_P}$). As will also be described in more detail below, during operation of amplifier 300, the first, second, and third variable networks 334, 340, 354 are controlled synchronously to establish impedance inverter configurations that will achieve desired peak efficiency power levels. The reconfigurability of the first, second, and third variable networks 334, 340, 354 (the impedance inverter) enables the correct / proper impedances to be established at the carrier and peaking amplifier outputs 332, 352 (i.e., the drain terminals of amplifiers 331, 351), which may ensure optimal signal amplification and post combining at full and reduced average output power levels.

As mentioned above, each of the carrier and peaking amplifiers 331, 351 is characterized by a parasitic drain-source capacitance 333, 353. According to one or more embodiments, the first variable network 334 functions to modify the parasitic drain-source capacitance 333 of the carrier amplifier 331, resulting in an effective output capacitance, $C_{EFF\_C}$, at the carrier amplifier output 332 that is different from (e.g., lower than) the parasitic drain-source capacitance 333. Similarly, the third variable network 354 functions to modify the parasitic drain-source capacitance 353 of the peaking amplifier 351, resulting in an effective output capacitance, $C_{EFF\_P}$, at the peaking amplifier output 352 that is different from (e.g., lower than) the parasitic drain-source capacitance 353. During operation, shunt inductances provided by the first and third variable networks 334, 354 function to resonate out some of the parasitic drain-source capacitances 333, 353. In other words, the carrier amplifier effective output capacitance, $C_{EFF\_C}$ (or the first shunt capacitance of the impedance inverter), is defined by the carrier amplifier parasitic drain-source capacitance 333 as modified by the first variable network 334, and the peaking amplifier effective output capacitance, $C_{EFF\_P}$ (or the second shunt capacitance of the impedance inverter), is defined by the peaking amplifier parasitic drain-source capacitance 353 as modified by the third variable network 354. It may be noted here that the peaking amplifier effective output capacitance, $C_{EFF\_P}$, also may be affected by the capacitance value of a laterdescribed first variable capacitance circuit 383 of the reconfigurable output impedance transformer 380.

According to one or more embodiments, in order to achieve optimal performance, the effective output capacitances, $C_{EFF\_C}$ and $C_{EFF\_P}$, associated with the carrier and peaking amplifiers 331, 351 may be controlled to be equal or approximately equal to each other, regardless of whether the Doherty power amplifier 300 is a symmetric or an asymmetric Doherty power amplifier. In other embodiments, the effective output capacitances, $C_{EFF\_C}$ and $C_{EFF\_P}$, may be controlled to be different from each other, while still achieving at least some of the benefits described herein.

In the embodiment illustrated in FIG. 3, the first variable network 334 includes a reconfigurable shunt inductance network coupled between the carrier amplifier output 332 and a ground reference node. Similarly, the third variable network 354 includes a reconfigurable shunt inductance network coupled between the peaking amplifier output 352 and the ground reference node. More specifically, each of the first and third variable networks 334, 354 include a number, $M$, of reconfigurable shunt inductance legs, where $M \geq 1$. For example, the number, $M$, of reconfigurable shunt inductance legs may be in a range of 1 to 5 or more. Although FIG. 3 depicts two reconfigurable shunt inductance legs in each of the first and third variable networks 334, 354, the ellipses between those legs indicate that each of the first and third variable networks 334, 354 may have more than two reconfigurable shunt inductance legs, as well.

Each shunt inductance leg includes an inductor 335, 336, 355, 356 coupled in series with a switching element 337, 338, 357, 358. Each of the shunt inductance legs in the first variable network 334 are coupled between the carrier amplifier output 332 and the ground reference node. Similarly, each of the shunt inductance legs in the third variable network 354 are coupled between the peaking amplifier output 352 and the ground reference node. More specifically, a first terminal of each inductor 335, 336, 355, 356 is coupled to the carrier or peaking amplifier output 332 or 352, and a second terminal of each inductor 335, 336, 355, 356 is coupled to a first terminal of a switching element 337, 338, 357, 358. Second terminals of the switching elements 337, 338, 357, 358 are coupled to the ground reference node. In alternate embodiments, the order of the inductor 335, 336, 355, 356 and the switch 337, 338, 357, 358 in each leg may be reversed (i.e., the switching elements 337, 338, 357, 358 may be connected between the amplifier outputs 332, 352 and first terminals of the inductors 335, 336, 355, 356, and second terminals of the inductors may be coupled to the ground reference node).

According to various embodiments, the inductance values of inductors 335 and 355 (referred to below as $L_{335}$, $L_{355}$) are equal to each other, and the inductance values of inductors 356 and 356 (referred to below as $L_{336}$ and $L_{356}$) are

equal to each other. However, the inductance values of inductors 335 and 336 may be equal or unequal, and the inductance values of inductors 355 and 356 may be equal or unequal. For example, in some embodiments, $L_{335} = L_{355}$ and $L_{336} = L_{356} = x \times L_{335}$, where $x \geq 1$. As a specific example, x may be equal to 2, meaning that the inductance values of inductors 336 and 356 are twice the inductance values of inductors 335 and 355. Other relative values of $L_{335}$, $L_{336}$, $L_{355}$, and $L_{356}$ alternatively could be implemented. Either way, at any given time, the effective output capacitances, $C_{EFF\_C}$ and $C_{EFF\_P}$ of the carrier and peaking amplifiers 331, 351, respectively, may have one of the following values:

- $C_{EFF\_C} = C_{333}$ and $C_{EFF\_P} = C_{353}$ (when switching elements 337, 338, 357, and 358 are open);

- $C_{EFF\_C} = C_{333} - \left( \dfrac{1}{\omega * \omega * L_{335}} \right)$ and $C_{EFF\_P} = C_{353} - \left( \dfrac{1}{\omega * \omega * L_{355}} \right)$ (when switching elements 337, 357 are closed and switching elements 338, 358 are open), where $\omega$ is the operational frequency (e.g., the fundamental frequency of operation, $f_0$);

- $C_{EFF\_C} = C_{333} - \left( \dfrac{1}{\omega * \omega * L_{336}} \right)$ and $C_{EFF\_P} = C_{353} - \left( \dfrac{1}{\omega * \omega * L_{356}} \right)$ (when switching elements 338, 358 are closed and switching elements 337, 357 are open); and

- $C_{EFF\_C} = C_{333} - \left( \dfrac{1}{\omega * \omega * L_{335}} \right) - \left( \dfrac{1}{\omega * \omega * L_{336}} \right)$ and

$C_{EFF\_P} = C_{353} - \left( \dfrac{1}{\omega * \omega * L_{355}} \right) - \left( \dfrac{1}{\omega * \omega * L_{356}} \right)$ (when switching elements 337, 338, 357, 358 are closed).

The inductance values selected for inductors 335, 336, 355, 356 may be based on the fundamental frequency of operation of the amplifier 300, $f_0$. For example, $f_0$ may be in a range of about 800 megahertz (MHz) to about 7 gigahertz (GHz), although $f_0$ may be lower or higher, as well. According to one or more embodiments, each of the inductors 335, 336, 355, 356 has an inductance value in a range of about 0.25 nanohenries (nH) to about 10 nH, although the inductance values may be lower or higher, as well.

According to one or more embodiments, the first and third variable networks 334, 354 may have similar or identical circuit topologies. For example, the first and third variable networks 334, 354 may have a same number, $M$, of shunt inductance legs. Further, in embodiments in which the Doherty power amplifier 300 is a symmetric amplifier, corresponding inductors in the first and third variable networks 334, 354 may have equal inductance values (e.g., inductors 335, 355 may have equal inductance values, inductors 336, 356 may have equal inductance values, and so on). Conversely, in embodiments in which the Doherty power amplifier 300 is an asymmetric amplifier, corresponding inductors in the first and third variable networks 334, 354 may have unequal but scaled inductance values (e.g., for a 2:1 peaking-to-carrier ratio, inductor 355 may have twice the inductance value as inductor 335, and so on).

As shown in FIG. 3, the series inductance of the impedance inverter is provided by the second variable network 340. In the embodiment illustrated in FIG. 3, the second variable network 340 includes a variable inductance network coupled between the carrier amplifier output 332 and the combining node 370. More specifically, the second variable network 340 includes a first inductor 341 and a number, $P$, of reconfigurable parallel inductance legs ($P \geq 1$) coupled in parallel with the first inductor 341. The first inductor 341 has a first terminal coupled to the carrier amplifier output 332, and a second terminal coupled to the combining node 370.

For example, the number, $P$, of reconfigurable parallel inductance legs may be in a range of 1 to 5 or more. The number, $P$, of reconfigurable parallel inductance legs in network 340 may or may not be equal to the number, $M$, of shunt inductance legs in networks 334 and 354. Although FIG. 3 depicts two reconfigurable parallel inductance legs in the second variable network 340, the ellipses between those legs indicate that the second variable network 340 may have more than two reconfigurable parallel inductance legs, as well.

Each reconfigurable parallel inductance leg includes an inductor 342, 343 coupled in series with one or more switching elements 345, 346, 347, 348. Each of the parallel inductance legs in the second variable network 340 are coupled between the carrier amplifier output 332 and the combining node 370. More specifically, a first terminal of each inductor 342, 343 may be coupled through a switching element 345, 347 to the carrier amplifier output 332, and a second terminal of each inductor 342, 343 may be coupled through another switching element 346, 348 to the combining node 370. In alternate embodiments, switching elements 345, 347 may be excluded, or alternatively, switching elements 346, 348 may be excluded.

According to various embodiments, the inductance values of inductors 341, 342, 343 (referred to below as $L_{341}$, $L_{342}$, $L_{343}$) may be equal or unequal. For example, in some embodiments, $L_{341} = L_{342} = L_{343}$. In other embodiments, $L_{342} = L_{341}$ and $L_{343} = 0.5 \times L_{341}$. Other relative values of $L_{341}$, $L_{342}$, and $L_{343}$ alternatively could be implemented. Either way, at any given time, the total inductance value, $L_{TOT}$, of the second variable network 340 between the carrier amplifier output 332 and the combining node 370 may have one of the following values:

- $L_{TOT} = L_{341}$ (when switching elements 345, 346, 347, 348 are open);
- $L_{TOT} = 1/(1/L_{341} + 1/L_{342})$ (when switching elements 345, 346 are closed and switching elements 347, 348 are open);
- $L_{TOT} = 1/(1/L_{341} + 1/L_{343})$ (when switching elements 345, 346 are open and switching elements 347, 348 are closed); and
- $L_{TOT} = 1/(1/L_{341} + 1/L_{342} + 1/L_{343})$ (when switching elements 345, 346, 347, 348 are closed).

The inductance values selected for inductors 341-343 may be based on the fundamental frequency of operation of the amplifier 300, $f_0$ (e.g., about 800 MHz to about 7 GHz). According to one or more embodiments, each of the inductors 341-343 has an inductance value in a range of about 1.0 nanohenries (nH) to about 10 nH, although the inductance values may be lower or higher, as well.

As discussed above, in the embodiment of the Doherty power amplifier 300 illustrated in FIG. 3, the series inductance that is provided by the second variable network 340 includes a first inductor 341 and a number, $P$, of reconfigurable parallel inductance legs ($P \geq 1$) coupled in parallel with the first inductor 341. According to one or more alternate embodiments, some or all of the inductors 341-343 may be replaced with transmission line (TL) segments.

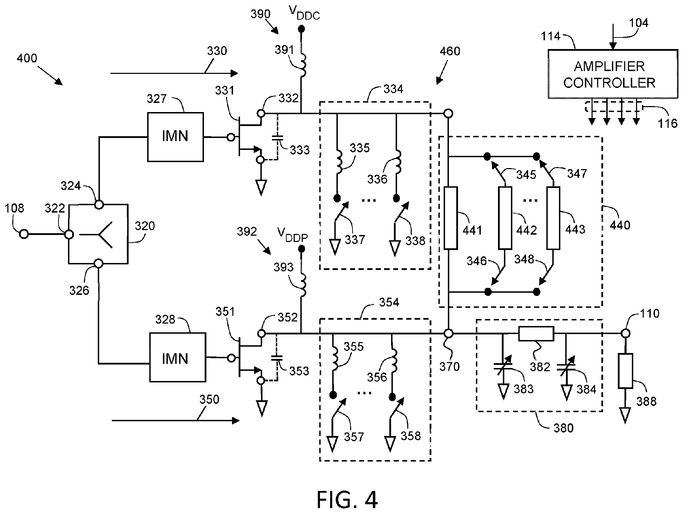

For example, FIG. 4 is a schematic drawing of a reconfigurable Doherty power amplifier 400, in accordance with another example embodiment in which a transmission-line-based, second variable network 440 is utilized. Except for differences between the second variable networks 340 (FIG. 3) and 440 (FIG. 4), all other features of Doherty power amplifier 400 are identical to (or substantially identical to) corresponding features of Doherty power amplifier 300. For brevity, the substantially identical features are not described again in detail. It should be understood that the descriptions of features of FIG. 3 (including descriptions of alternate embodiments) with the same reference number as corresponding features in FIG. 4 apply also to the Doherty power amplifier 400 of FIG. 4.

As shown in FIG. 4, an effective series impedance of the impedance inverter is provided by the second variable network 440. In the embodiment illustrated in FIG. 4, the second variable network 440 includes a variable transmission line (TL) network coupled between the carrier amplifier output 332 and the combining node 370. More specifically, the second variable network 440 includes a first transmission line (TL) segment 441 and a number, $P$, of reconfigurable parallel TL legs ($P \geq 1$) coupled in parallel with the first TL segment 441. The first parallel TL segment 441 has a first end coupled to the carrier amplifier output 332, and a second end coupled to the combining node 370.

For example, the number, $P$, of reconfigurable parallel TL legs may be in a range of 1 to 5 or more. Again, the number, $P$, of reconfigurable parallel inductance legs in network 440 may or may not be equal to the number, $M$, of shunt inductance legs in networks 334 and 354. Although FIG. 4 depicts two reconfigurable parallel TL legs in the second variable network 440, the ellipses between those legs indicate that the second variable network 440 may have more than two reconfigurable parallel TL legs, as well.

Each reconfigurable parallel TL leg includes a TL segment 442, 443 coupled in series with one or more switching elements 345, 346, 347, 348. Each of the TL legs in the second variable network 440 are coupled between the carrier amplifier output 332 and the combining node 370. More specifically, a first end of each parallel TL segment 442, 443 may be coupled through a switching element 345, 347 to the carrier amplifier output 332, and a second end of each parallel TL segment 442, 443 may be coupled through another switching element 346, 348 to the combining node 370. In alternate embodiments, switching elements 345, 347 may be excluded, or alternatively, switching elements 346, 348 may be excluded.

According to various embodiments, each of the parallel TL segments 441, 442, 443 is defined by a characteristic impedance, $Z$, and an electrical length, $\beta$. The characteristic impedance values of the parallel TL segments 441, 442, 443 (referred to below as $Z_{441}, Z_{442}, Z_{443}$) may be equal or unequal. For example, in some embodiments, $Z_{441} = Z_{442} = Z_{443}$. In other embodiments, $Z_{442} = Z_{341}$ and $Z_{443} = 0.5 \times Z_{441}$. Other relative values of $Z_{441}, Z_{442},$ and $Z_{443}$ alternatively could be implemented. Similarly, the electrical lengths of the parallel TL segments 441, 442, 443 (referred to below as $\beta_{441}, \beta_{442}, \beta_{443}$) may be equal or unequal. For space and layout purposes, it may be desirable for the parallel TL segments 441-443 to have the same electrical (and physical) lengths. As will be described below, this may be possible with coordinated selection of characteristic impedance values, $Z_{441}, Z_{442}, Z_{443}$, and coordinated control of the effective output capacitances, $C_{EFF\_C}, C_{EFF\_P}$, of the carrier and peaking amplifiers 331, 351.

Either way, at any given time, the total impedance value, $Z_{TOT}$, of the second variable network 440 between the carrier amplifier output 332 and the combining node 370 may have one of the following values:

- $Z_{TOT} = Z_{441}$ (when switching elements 345, 346, 347, 348 are open);
- $Z_{TOT} = 1/(1/Z_{441} + 1/Z_{442})$ (when switching elements 345, 346 are closed and switching elements 347, 348 are open);
- $Z_{TOT} = 1/(1/Z_{441} + 1/Z_{443})$ (when switching elements 345, 346 are open and switching elements 347, 348 are closed); and
- $Z_{TOT} = 1/(1/Z_{441} + 1/Z_{442} + 1/Z_{443})$ (when switching elements 345, 346, 347, 348 are closed).

The impedance values and electrical lengths selected for the parallel TL segments 441-443 may be based on the fundamental frequency of operation of the amplifier 400, $f_0$ (e.g., about 800 MHz to about 7 GHz). According to one or more embodiments, each of the parallel TL segments 441-443 has an impedance value in a range of about 30 Ohms to about 100 Ohms, although the impedance values may be lower or higher, as well. Further, according to one or more embodiments, each of the parallel TL segments 441-443 has an electrical length in a range of about 45 degrees to about 90 degrees, although the electrical lengths may be lower or higher, as well.

As discussed above, both of the embodiments of the Doherty power amplifiers 300, 400 illustrated in FIGs 3 and 4 include a second variable network 340, 440 that includes a first inductor 341 or TL segment 441 and a number, $P$, of reconfigurable parallel inductance or TL legs ($P \geq 1$) coupled in parallel with the first inductor 341 or TL segment 441. According to one or more alternate embodiments, a different topology could be implemented for the second variable network in order to provide the series inductance of the impedance inverter.

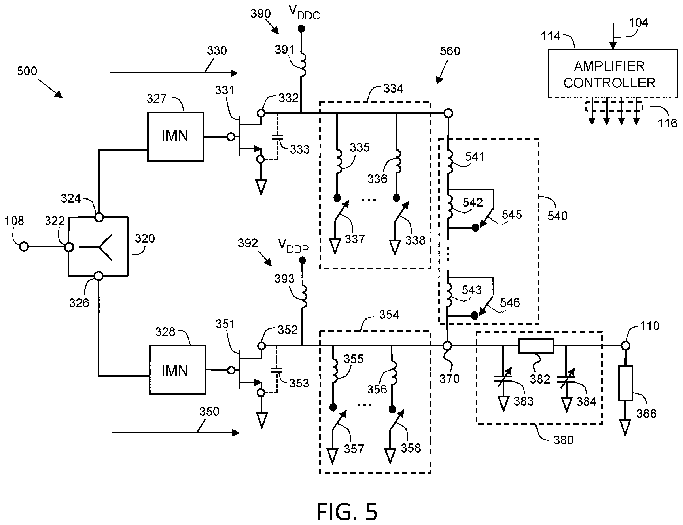

For example, FIG. 5 is a schematic drawing of a reconfigurable Doherty power amplifier 500, in accordance with another example embodiment in which the second variable network 540 includes a first inductor 341 and a number, $Q$, of bypassable inductors 542, 543 coupled in series with the first inductor 341. As used herein, the term "bypassable inductor" means an inductor with a switching element coupled across the inductor terminals, such that when the switching element is open, substantially all current flows through the inductor, and when the switching element is closed, substantially all current flows through the switching element, thus bypassing the inductor. Except for differences between the second variable networks 340 (FIG. 3) and 540 (FIG. 5), all other features of Doherty power amplifier 500 are identical to (or substantially identical to) corresponding features of Doherty power amplifier 300. For brevity, the substantially identical features are not described again in detail. It should be understood that the descriptions of features of FIG. 3 (including descriptions of alternate embodiments) with the same reference number as corresponding features in FIG. 5 apply also to the Doherty power amplifier 500 of FIG. 5.

As shown in FIG. 5, the series inductance of the impedance inverter is provided by the second variable network 540. In the embodiment illustrated in FIG. 5, the second variable network 540 includes a plurality of inductors 541, 542, 543 coupled in series between the carrier amplifier output 332 and the combining node 370, with bypass switches 545, 546 coupled across the terminals of some of the inductors 542, 543. More specifically, the second variable network 540 includes a first inductor 541 and a number, $Q$, of reconfigurable (bypassable) inductors 542, 543 ($Q \geq 1$) coupled in series with the first inductor 541. The first inductor 541 has a first terminal coupled to the carrier amplifier output 332, and a second terminal coupled to a first terminal of a first bypassable inductor 542. The second terminal of the first bypassable inductor 542 may be coupled to the combining node 370 (when $Q = 1$), or alternatively (when $Q > 1$) to a series of one or more additional bypassable inductors, with the $q$th bypassable inductor 543 being the last inductor in the series. The second terminal of the $q$th bypassable inductor 543 is coupled to the combining node 370.

For example, the number, $Q$, of bypassable inductors 542, 543 may be in a range of 1 to 5 or more. Although FIG. 5 depicts two bypassable inductors 542, 543 in the second variable network 540, the ellipses between those inductors 542, 543 indicate that the second variable network 540 may have more than two bypassable inductors 542, 543, as well.

A bypass switch 545, 546 is coupled across the first and second terminals of each bypassable inductor 542, 543. When a bypass switch 545, 546 is in an "open" or "off" state, the inductance of the corresponding inductor 542, 543 will add to the inductance of the first inductor 541 between the carrier amplifier output 332 and the combining node 370. Conversely, when a bypass switch 545, 546 is in a "closed" or "on" state, the corresponding inductor 542, 543 will be bypassed through the switch 545, 546, and the inductance of the corresponding inductor 542, 543 will not add to the inductance of the first inductor 541 between the carrier amplifier output 332 and the combining node 370.

According to various embodiments, the inductance values of inductors 541, 542, 543 (referred to below as $L_{541}$, $L_{542}$, $L_{543}$) may be equal or unequal. For example, in some embodiments, $L_{541} = L_{542} = L_{543}$. In other embodiments, $L_{542} = x \times L_{541}$ and $L_{543} = y \times L_{541}$, where $x$ and $y$ can have any non-zero value. Either way, at any given time, the total inductance value, $L_{TOT}$, of the second variable network 540 between the carrier amplifier output 332 and the combining node 370 may have one of the following values:

- $L_{TOT} = L_{541}$ (when bypass switches 545, 546 are closed);
- $L_{TOT} = L_{541} + L_{542}$ (when bypass switch 545 is open and bypass switch 546 is closed);
- $L_{TOT} = L_{541} + L_{543}$ (when bypass switch 545 is closed and bypass switch 546 is open); and
- $L_{TOT} = L_{541} + L_{542} + L_{543}$ (when bypass switches 545 and 546 are open).

The inductance values selected for inductors 541-543 may be based on the fundamental frequency of operation of the amplifier 500, $f_0$ (e.g., about 800 MHz to about 7 GHz). According to one or more embodiments, each of the inductors 541-543 has an inductance value in a range of about 1.0 nanohenries (nH) to about 10 nH, although the inductance values may be lower or higher, as well.

For each of the embodiments of Doherty power amplifiers 300, 400, 500 (FIGs 3-5) discussed above, and according to one or more embodiments, each of the switching elements 337, 338, 345-348, 545-547, 357, 358 may be implemented as an active switching device (e.g., a field effect transistor (FET)) with a control terminal (e.g., a gate terminal) and current conducting terminals (e.g., drain and source terminals). For example, the switching elements 337, 338, 345-348, 545-547, 357, 358 may include metal oxide semiconductor FETs (MOSFETs), high electron mobility transistors (HEMTs), metal-semiconductor field effect transistors (MESFETs), laterally diffused metal-oxide semiconductor (LDMOS) FETs, Enhancement-mode MOSFETs (EMOSFETs), and/or junction gate FETs (JFETs), to name a few.

During operation of the Doherty power amplifiers 300, 400, 500, the states of the first, second, and third variable networks 334, 340 or 440 or 540, 354 may be reconfigured synchronously (e.g., through switch control signals provided over switch control lines 116). Said another way, to establish any one of the *N* configurations for the amplifier 300, 400, 500, the states of all switching elements 337, 338, 345-348, 545-547, 357, 358 are controlled by the amplifier controller 114 in a synchronous manner. Each of the switching elements 337, 338, 345-348, 545-547, 357, 358 may be "turned off" or "opened" (e.g., placed in a state of high impedance between drain and source terminals) or "turned on" or "closed" (e.g., placed in a state of low impedance between drain and source terminals) based on switch control signals provided to the control terminal of the switching element. According to one or more embodiments, in order to provide the switch control signals, the amplifier controller 114 may include multiple drivers (not shown), where each driver is coupled through the switch control lines 116 to one or more of the control terminals of the switching elements 337, 338, 345-348, 545-547, 357, 358.

According to one or more embodiments, during operation of the amplifier 300, 400, 500, the first and third variable networks 334, 354 may be controlled synchronously to have a same configuration at any given time. For example, when switch control signals are provided to the first variable network 334 that causes all of the switching elements 337, 338 to be "closed", simultaneous switch control signals are provided to the third variable network 354 that cause both of the switching elements 357, 358 to be "closed". In such a configuration, inductors 335 and 336 function to resonate out some of drain-source capacitance 333, and inductors 355, 356 function to resonate out some of drain-source capacitance 353. Similarly, when switch control signals are provided to the first variable network 334 that cause switching element 337 to be "closed" and switching element 338 to be "opened", simultaneous switch control signals are provided to the third variable network 354 that cause switching element 357 to be "closed" and switching element 358 to be "opened". In such a configuration, only inductor 335 functions to resonate out some of drain-source capacitance 333, and only inductor 355 functions to resonate out some of drain-source capacitance 353. According to one or more embodiments, the second variable network 340 also is reconfigured synchronously with reconfiguring the first and third variable networks 334, 354.

As indicated above, at any given time, Doherty power amplifier 300 may be configured or reconfigured into any one of *N* amplifier states, with each amplifier state corresponding either to a full power state or to a backoff power state (e.g., selected from one or more backoff power states). As discussed previously in conjunction with FIGs 1 and 2, the instantaneous configuration of Doherty power amplifier 300, 400, 500 may be controlled by the amplifier controller 114 based on control signals 104 from a base station controller 103 (FIG. 1).

According to an embodiment, the amplifier controller 114 includes memory (not shown) configured to store a lookup table that correlates the control signals 104 from the base station controller 103 with switch states for the plurality of switching elements 337, 338, 345-348, 357, 358 within the embodiments of Doherty power amplifier 300, 400 shown in FIGs 3, 4.

To illustrate, below is a first example of a lookup table (Table 3) that may be utilized in conjunction with a reconfigurable Doherty power amplifier 300, 400 that includes only one reconfigurable shunt inductance leg in each of the first and third variable networks 334, 354 (i.e., *M* = 1, corresponding to inductors 335, 355 and switching elements 337, 357), and only one reconfigurable series inductance (or series TL) leg in the second variable network (i.e., *P* = 1, corresponding to inductor 342 or TL 442 and switching elements 345, 346). Although such a reconfigurable Doherty power amplifier 300, 400 theoretically may be selectively configured, at any given time, into any of four possible amplifier states, it may be that some of the theoretically possible amplifier states do not produce acceptable performance. Accordingly, the system may be configured so that only some of the theoretically possible amplifier states are selectable (e.g., those states that produce acceptable performance). The below lookup table includes entries for two amplifier states (i.e., *N* = 2, corresponding to a full power state and a single backoff power state).

Table 3 - Switch states for N=2 state amplifier 300, 400

| AMPLIFIER STATE | SWITCH STATE FOR SWITCHES 337, 357 | SWITCH STATE FOR SWITCHES 345, 346 |
|---|---|---|
| FULL POWER (STATE 1) | OPEN | CLOSED |
| BACKOFF POWER (STATE 2) | CLOSED | OPEN |

As Table 3 indicates, when the amplifier controller 114 receives a control signal 104 from the base station controller 103 that indicates that the amplifier 300, 400 should be reconfigured into a full power state (state 1, with 0 dB backoff), the amplifier controller 114 will provide switch control signals over switch control lines 116 that:

- cause switching elements 337, 357 to be in an open state (i.e., inductors 335, 355 do not affect the effective output capacitance of amplifiers 331, 351); and
- cause switching elements 345, 346 to be in a closed state (i.e., the inductance of network 340 includes the parallel inductances 341, 342, or the impedance of network 440 includes the parallel TLs 441, 442).

Alternatively, when the amplifier controller 114 receives a control signal 104 from the base station controller 103 that indicates that the amplifier 300, 400 should be reconfigured into a backoff power state (state 2, with 3 dB backoff), the amplifier controller 114 will provide switch control signals over switch control lines 116 that:

- cause switching elements 337, 357 to be in a closed state (i.e., inductors 335, 355 affect (reduce) the effective output capacitance of amplifiers 331, 351); and
- cause switching elements 345, 346 to be in an open state (i.e., the inductance of network 340 includes only inductor 341, or the impedance of network 440 includes only the TL 441).

As another example, below is a second example of a lookup table (Table 4) that may be utilized in conjunction with a reconfigurable Doherty power amplifier 300, 400 that includes two reconfigurable shunt inductance legs in each of the first and third variable networks 334, 354 (i.e., $M = 2$, corresponding to inductors 335, 336, 355, 356 and switching elements 337, 338, 357, 358), and two reconfigurable series inductance (or series TL) leg in the second variable network 340 or 440 (i.e., $P = 2$, corresponding to inductors 342, 343 or TLs 442, 443 and switching elements 345-348). Although such a reconfigurable Doherty power amplifier 300, 400 theoretically may be selectively configured, at any given time, into any of eight (or more) possible amplifier states, it may be that some of the theoretically possible amplifier states do not produce acceptable performance. Accordingly, the system may be configured so that a subset of the theoretically possible amplifier states are selectable (e.g., those states that produce acceptable performance). The below lookup table includes entries for three amplifier states (i.e., $N = 3$, corresponding to a full power state and two backoff power states). Those of skill in the art would understand, based on the description herein, that Doherty power amplifiers 300, 400 theoretically could support more than three amplifier states.

Table 4 - Switch states for N=3 state amplifier 300, 400

| AMPLIFIER STATE | SWITCH STATE FOR SWITCHES 337, 357 | SWITCH STATE FOR SWITCHES 338, 358 | SWITCH STATE FOR SWITCHES 345, 346 | SWITCH STATE FOR SWITCHES 347, 348 |
|---|---|---|---|---|
| FULL POWER (STATE 1) | OPEN | OPEN | CLOSED | CLOSED |
| FIRST BACKOFF POWER (STATE 2) | CLOSED | OPEN | CLOSED | OPEN |
| SECOND BACKOFF POWER (STATE 3) | CLOSED | CLOSED | OPEN | OPEN |

As Table 4 indicates, when the amplifier controller 114 receives a control signal 104 from the base station controller 103 that indicates that the amplifier 300, 400 should be reconfigured into a full power state (state 1, with 0 dB backoff), the amplifier controller 114 will provide switch control signals over switch control lines 116 that:

- cause switching elements 337, 357, 338, and 358 to be in an open state (i.e., inductors 335, 336, 355, 356 do not affect the effective output capacitance of amplifiers 331, 351); and

- cause switching elements 345-348 to be in a closed state (i.e., the inductance of network 340 includes the parallel inductances 341, 342, and 343, or the impedance of network 440 includes the parallel TLs 441, 442, and 443).

Alternatively, when the amplifier controller 114 receives a control signal 104 from the base station controller 103 that indicates that the amplifier 300, 400 should be reconfigured into a first backoff power state (state 2, with 3 dB backoff), the amplifier controller 114 will provide switch control signals over switch control lines 116 that:

- cause switching elements 337, 357 to be in a closed state (i.e., inductors 335, 355 affect (reduce) the effective output capacitance of amplifiers 331, 351);
- cause switching elements 338, 358 to be in an open state (i.e., inductors 336, 356 do not affect the effective output capacitance of amplifiers 331, 351); and

- cause switching elements 345, 346 to be in a closed state, and switching elements 347, 348 to be in an open state (i.e., the inductance of network 340 includes inductors 341, 342, or the impedance of network 440 includes TLs 441, 442).

Alternatively, when the amplifier controller 114 receives a control signal 104 from the base station controller 103 that indicates that the amplifier 300, 400 should be reconfigured into a second backoff power state (state 3, with 6 dB backoff), the amplifier controller 114 will provide switch control signals over switch control lines 116 that:

- cause switching elements 337, 338, 357, 358 to be in a closed state (i.e., inductors 335, 336, 355, 356 affect (reduce) the effective output capacitance of amplifiers 331, 351); and
- cause switching elements 345-348 to be in an open state (i.e., the inductance of network 340 includes only inductor 341, or the impedance of network 440 includes only TL 441).

As another example, below is an alternative example of a lookup table (Table 5) that includes two reconfigurable shunt inductance legs in each of the first and third variable networks 334, 354 (i.e., $M= 2$), and two reconfigurable series inductance (or series TL) leg in the second variable network 340 or 440 (i.e., $P = 2$). Again, although such a reconfigurable Doherty power amplifier 300, 400 theoretically may be selectively configured, at any given time, into any of eight (or more) possible amplifier states, it may be that some of the theoretically possible amplifier states do not produce acceptable performance. Accordingly, the system may be configured so that a subset of the theoretically possible amplifier states are selectable (e.g., those states that produce acceptable performance). The below lookup table includes entries for three amplifier states (i.e., $N = 3$, corresponding to a full power state and two backoff power states). Those of skill in the art would understand, based on the description herein, that Doherty power amplifiers 300, 400 theoretically could support more than three amplifier states.

Table 5 - Alternative switch states for N=3 state amplifier 300, 400

| AMPLIFIER STATE | SWITCH STATE FOR SWITCHES 337, 357 | SWITCH STATE FOR SWITCHES 338, 358 | SWITCH STATE FOR SWITCHES 345, 346 | SWITCH STATE FOR SWITCHES 347, 348 |
|---|---|---|---|---|
| FULL POWER (STATE 1) | OPEN | OPEN | CLOSED | CLOSED |
| FIRST BACKOFF POWER (STATE 2) | OPEN | CLOSED | OPEN | CLOSED |
| SECOND BACKOFF POWER (STATE 3) | CLOSED | CLOSED | OPEN | OPEN |

As Table 5 indicates, when the amplifier controller 114 receives a control signal 104 from the base station controller 103 that indicates that the amplifier 300, 400 should be reconfigured into a full power state (state 1, with 0 dB backoff), the amplifier controller 114 will provide switch control signals over switch control lines 116 that:

- cause switching elements 337, 357, 338, and 358 to be in an open state (i.e., inductors 335, 336, 355, 356 do not affect the effective output capacitance of amplifiers 331, 351); and

- cause switching elements 345-348 to be in a closed state (i.e., the inductance of network 340 includes the parallel inductances 341, 342, and 343, or the impedance of network 440 includes the parallel TLs 441, 442, and 443).

Alternatively, when the amplifier controller 114 receives a control signal 104 from the base station controller 103 that indicates that the amplifier 300, 400 should be reconfigured into a first backoff power state (state 2, with 3 dB backoff), the amplifier controller 114 will provide switch control signals over switch control lines 116 that:

- cause switching elements 337, 357 to be in an open state (i.e., inductors 335, 355 do not affect the effective output capacitance of amplifiers 331, 351);
- cause switching elements 338, 358 to be in a closed state (i.e., inductors 336, 356 affect (reduce) the effective output capacitance of amplifiers 331, 351); and
- cause switching elements 345, 346 to be in an open state, and switching elements 347, 348 to be in a closed state (i.e., the inductance of network 340 includes inductors 341, 343, or the impedance of network 440 includes TLs 441, 443).

Alternatively, when the amplifier controller 114 receives a control signal 104 from the base station controller 103 that indicates that the amplifier 300, 400 should be reconfigured into a second backoff power state (state 3, with 6 dB backoff), the amplifier controller 114 will provide switch control signals over switch control lines 116 that:

- cause switching elements 337, 338, 357, 358 to be in a closed state (i.e., inductors 335, 336, 355, 356 affect (reduce) the effective output capacitance of amplifiers 331, 351); and
- cause switching elements 345-348 to be in an open state (i.e., the inductance of network 340 includes only inductor 341, or the impedance of network 440 includes only TL 441).

As discussed above, reconfigurable Doherty power amplifiers 300, 400 each include second variable networks 340, 440 with parallel-coupled, reconfigurable inductor or TL legs. Conversely, reconfigurable Doherty power amplifier 500 includes a second variable network 540 with series-coupled, bypassable inductors. The series-coupled nature of the switching elements 545, 546 in reconfigurable Doherty power amplifier 500 warrants a different switch control process for amplifier 500.

Accordingly, as another example, below is a lookup table (Table 6) that may be utilized in conjunction with a reconfigurable Doherty power amplifier 500 that includes two reconfigurable shunt inductance legs in each of the first and third variable networks 334, 354 (i.e., $M$= 2, corresponding to inductors 335, 336, 355, 356 and switching elements 337, 338, 357, 358), and two reconfigurable (bypassable) inductors in the second variable network 540 (i.e., $P$ = 2, corresponding to inductors 542, 543 and switching elements 545, 546). Although such a reconfigurable Doherty power amplifier 500 theoretically may be selectively configured, at any given time, into any of eight (or more) possible amplifier states, it may be that some of the theoretically possible amplifier states do not produce acceptable performance. Accordingly, the system may be configured so that a subset of the theoretically possible amplifier states are selectable (e.g., those states that produce acceptable performance). The below lookup table includes entries for three amplifier states (i.e., $N$ = 3, corresponding to a full power state and two backoff power states). Those of skill in the art would understand, based on the description herein, that Doherty power amplifier 500 theoretically could support more than three amplifier states.

Table 6 - Switch states for N=3 state amplifier 500

| AMPLIFIER STATE | SWITCH STATE FOR SWITCHES 337, 357 | SWITCH STATE FOR SWITCHES 338, 358 | SWITCH STATE FOR SWITCH 545 | SWITCH STATE FOR SWITCH 546 |
| --- | --- | --- | --- | --- |
| FULL POWER (STATE 1) | OPEN | OPEN | CLOSED | CLOSED |
| FIRST BACKOFF POWER (STATE 2) | CLOSED | OPEN | CLOSED | OPEN |
| SECOND BACKOFF POWER (STATE 3) | CLOSED | CLOSED | OPEN | OPEN |

As Table 6 indicates, when the amplifier controller 114 receives a control signal 104 from the base station controller 103 that indicates that the amplifier 500 should be reconfigured into a full power state (state 1, with 0 dB backoff), the amplifier controller 114 will provide switch control signals over switch control lines 116 that:

- cause switching elements 337, 357, 338, and 358 to be in an open state (i.e., inductors 335, 336, 355, 356 do not affect the effective output capacitance of amplifiers 331, 351); and

- cause switching elements 545, 546 to be in a closed state (i.e., the inductance of network 540 does not include the series inductances 542, 543).

Alternatively, when the amplifier controller 114 receives a control signal 104 from the base station controller 103 that indicates that the amplifier 500 should be reconfigured into a first backoff power state (state 2, with 3 dB backoff), the amplifier controller 114 will provide switch control signals over switch control lines 116 that:

- cause switching elements 337, 357 to be in a closed state (i.e., inductors 335, 355 affect (reduce) the effective output capacitance of amplifiers 331, 351);
- cause switching elements 338, 358 to be in an open state (i.e., inductors 336, 356 do not affect the effective output capacitance of amplifiers 331, 351); and
- cause switching element 545 to be in a closed state, and switching element 546 to be in an open state (i.e., the inductance of network 540 includes inductors 541 and 543 but does not include inductor 542).

Alternatively, when the amplifier controller 114 receives a control signal 104 from the base station controller 103 that indicates that the amplifier 500 should be reconfigured into a second backoff power state (state 3, with 6 dB backoff), the amplifier controller 114 will provide switch control signals over switch control lines 116 that:

- cause switching elements 337, 338, 357, 358 to be in a closed state (i.e., inductors 335, 336, 355, 356 affect (reduce) the effective output capacitance of amplifiers 331, 351); and
- cause switching elements 545, 546 to be in an open state (i.e., the inductance of network 540 includes inductors 541, 542, and 543).

For each of the Doherty power amplifiers 300, 400, 500 (FIGs 3-5), the above-described configurations provide correct phase relationships for optimal load modulation, and ensure that the amplified signals from the carrier and peaking paths 330, 350 arrive in phase (or coherently) at the combining node 370. Combining node 370 includes a conductive structure that is suitable for combining the amplified RF signals produced by the carrier and peaking amplification paths 330, 350 in order to produce an amplified combined output RF signal. In some embodiments, the combining node 370 may be co-located with or correspond to the output 352 (e.g., the drain terminal) of the peaking amplifier 351.

According to an embodiment, a variable output impedance transformer 380 is coupled between the combining node 370 and the RF output 110. During operation of amplifier 300, 400, 500, the variable output impedance transformer 380 is configured to transform the impedance at RF output 110 to the impedance at combining node 370. Accordingly, the impedance at the combining node 370 is established by the reconfigurable output impedance transformer 380. Specifically, the impedance at the combining node 370 is dependent on the power level where it is desired to have the first efficiency peak (e.g., points 212, 222, 232, 242 FIG. 2). During operation, the variable output impedance transformer 380 is controlled to establish the correct combining node impedance for the desired power level in backoff conditions.

According to one or more embodiments, the variable output impedance transformer 380 includes a phase shift element 382 (e.g., a transmission line segment or an inductor) with a first end (or first terminal) coupled to the combining node 370, and a second end (or second terminal) coupled to the RF output 110. In addition, the variable output impedance transformer 380 includes a first variable capacitance circuit 383 coupled between the first end of the phase shift element 382 and a ground reference node, and a second variable capacitance circuit 384 coupled between the second end of the phase shift element 382 and the ground reference node.

The phase shift element 382 is characterized by a characteristic impedance, $Z_1$, and an electrical length (or phase shift) at the center frequency of operation, $f_0$, of the amplifier 300, 400, 500. For example, the impedance, $Z_1$, may be in a range of about 20 to about 100, and the electrical length may be in a range of about 15 degrees to about 90 degrees, although the electrical length may be shorter or longer, as well.

In various embodiments, each of the first variable capacitance circuit 383 and the second variable capacitance circuit 384 may be implemented with a tunable capacitor, such as but not by way of limitation, a voltage-controlled variable capacitor (VVAC), a digitallycontrolled variable capacitor (DVC) (also known as a digitally-programmable capacitor or a digitally-tunable capacitor), or another suitable tunable/variable capacitor. The instantaneous capacitance values of the first and second variable capacitance circuits 383, 384 may be modified based on control signals from the amplifier controller 114. For example, a VVAC is a component with a capacitance value between first and second terminals that can be varied according to a control voltage applied to a tuning input (not shown). A DVC is a component with a capacitance value between first and second terminals that can be varied based on a digital value that is programmed (e.g., via a serial interface, not shown) into a digital register of the DVC. The DVC may be implemented with an array of switched capacitors, for example. The RF switches in the DVC may be semiconductor switches, such as gallium arsenide (GaAs), gallium nitride (GaN), or silicon-on-insulator (SOI) switches, or alternatively the RF switches may be switching devices that use phase change materials (PCM), such as germanium telluride (GeTe) or germaniumantimony-tellurium (GeSbTe). Any other suitable RF switch technology alternatively may be used.

Each of the first and second variable capacitance circuits 383, 384 may be tunable across a range of capacitance values between a minimum capacitance value, $C_{MIN}$, and a maximum capacitance value, $C_{MAX}$. For example, the minimum capacitance value, $C_{MIN}$, may be between about 0.2 pF and about 0.6 pF, and the maximum capacitance value, $C_{MAX}$, may be between about 0.9 pF and about 2.0 pF. The minimum and/or maximum capacitance values for the first and second variable capacitance circuits 383, 384 may be lower or higher, as well. During operation, the capacitance values of the first and second variable capacitance circuits 383, 384 may be controlled to be approximately equal, or the capacitance values may be controlled to be unequal.

According to one or more embodiments, the capacitance values of the first and second variable capacitance circuits 383, 384 are controlled to establish a desired impedance, $Z_0$, at the combining node 370 that corresponds to the amplifier state (e.g., full power state or a backoff power state). For example, the variable capacitance circuits 383, 384 may be controlled to have capacitance values that establish a relatively low combining node impedance, $Z_0$ (e.g., from 10-15 ohms) when the reconfigurable Doherty power amplifier 300, 400, 500 is in the full power state (e.g., 0 dB backoff), and the variable capacitance circuits 383, 384 may be controlled to have capacitance values that establish a relatively high combining node impedance, $Z_0$ (e.g., from 20-30 ohms) when the reconfigurable Doherty power amplifier 300, 400, 500 is in a first backoff state (e.g., 3 dB backoff). According to an embodiment, the variable capacitance circuits 383, 384 str controlled to have capacitance values that result in doubling the combining node impedance, $Z_0$, for each 3 dB of desired backoff.

To provide additional clarity, an example implementation will now be discussed of an asymmetric (2:1 peaking-to-carrier ratio) reconfigurable Doherty power amplifier (e.g., amplifier 300, FIG. 3) that may be selectively configured into either of two amplifier states (i.e., $N= 2$). In the example implementation, all inductors 335, 341, 342, 355 (FIG. 3) may have substantially equal inductance values (e.g., about 3.9 nH for example purposes only). In such an example embodiment, the reconfigurable Doherty power amplifier may be characterized by the following parameters in a full power state (state 1) and in a single backoff power state (state 2) at 3 dB below the full power state:

Table 7 - Implementation of asymmetric Doherty power amplifier with N=2 amplifier states

| PARAMETER - UNIT | FULL POWER (STATE 1) | BACKOFF POWER (STATE 2) |
|---|---|---|
| $P_{carrier}$ - W | 21.03 | 10.54 |
| $P_{peaking}$ - W | 42.06 | 21.08 |
| $R_o$ - Ohms | 14.65 | 29.23 |
| $C_{EFF\_c}$ - pF | 1.00 | 0.50 |
| $C_{EFF\_p}$ - pF | 1.00 | 0.50 |
| $L_{TOT}$ - nH | 1.94 | 3.88 |

In the above table (and also in Tables 8 and 9, below), $P_{carrier}$ is the maximum output power of the carrier amplifier 331, $P_{peaking}$ is the maximum output power of the peaking amplifier 351, and $R_o$ is the impedance at the combining node 370 looking to the right. The different values of $R_o$ for the full power state and for the backoff power state result from different configurations of the variable capacitance circuits 383, 384 in the reconfigurable output impedance transformer 380. As the example parameter values indicate, the impedance at the combining node 370, $R_o$, has a first value (i.e., 14.65 Ohms) when the amplifier is configured in the full power state, and the combining node impedance has a second value (i.e., 29.23 Ohms) that is about twice the first value when the amplifier is configured in the first backoff power state. Further, the effective capacitances at the power amplifier outputs 332, 352, $C_{EFF}$, have first values (i.e., 1.00 pF) when the amplifier is configured in the full power state, and the effective capacitances at the power amplifier outputs 332, 352 have second values (i.e., 0.50 pF) that are about half the first value when the amplifier is configured in the first backoff power state. Further still, the total inductance of the second variable network 340, $L_{TOT}$, has a first value (i.e., 1.94 nH) when the amplifier is configured in the full power state, and the total inductance of the second variable network 340 has a second value (i.e., 3.88 nH) when the amplifier is configured in the first backoff power state.

The above example illustrates that effective control of the reconfigurable Doherty power amplifier 300 to transition to a backoff power state that is about 3 dB below the full power state includes simultaneously:

- reconfiguring the variable output impedance transformer 380 to increase (e.g., double) the combining node impedance;
- reconfiguring the first and third variable networks 334, 354 to decrease (e.g., halve) the effective capacitances, $C_{EFF}$, at the outputs 332, 352 of the power amplifiers 331, 351; and
- reconfiguring the second variable network 340 to increase (e.g., double) the total inductance, $L_{TOT}$, of the second variable network 340.

Interestingly, for Doherty power amplifier 300 (FIG. 3), the values of $C_{EFF}$ and $L_{TOT}$ are controlled in an inverse manner (i.e., as $C_{EFF}$ is decreased, $L_{TOT}$ is increased, and vice versa). It should be noted here that, for the alternate embodiments of Doherty power amplifiers 400, 500 shown in FIGs 4 and 5, similar relative control of the values of $C_{EFF}$ and $Z_{TOT}$ (FIG. 4) or $C_{EFF}$ and $L_{TOT}$ (FIG. 5) would apply.

An additional example implementation will now be discussed of an asymmetric (2:1 peaking-to-carrier ratio) reconfigurable Doherty power amplifier (e.g., amplifier 300, FIG. 3) that may be selectively configured into any of three amplifier states (i.e., $N = 3$). In the example implementation, inductors 335, 343, and 356 (FIG. 3) may have substantially equal first inductance values (e.g., about 3.9 nH for example purposes only), and inductors 336, 356, 341, and 342 (FIG. 3) may have substantially equal second inductance values (e.g., about 7.7 nH). In such an example embodiment, the reconfigurable Doherty power amplifier may be characterized by the following parameters in a full power state (state 1), in a first backoff power state (state 2) at 3 dB below the full power state, and in a second backoff power state (state 3) at 6 dB below the full power state:

Table 8 - Implementation of asymmetric Doherty power amplifier with $N$=3 amplifier states

| PARAMETER - UNIT | FULL POWER (STATE 1) | FIRST BACKOFF POWER (STATE 2) | SECOND BACKOFF POWER (STATE 3) |
|---|---|---|---|
| $P_{carrier}$ - W | 21.03 | 10.54 | 5.28 |
| $P_{peaking}$ - W | 42.06 | 21.08 | 10.56 |
| $R_o$ - Ohms | 14.65 | 29.23 | 58.32 |
| $C_{EFF\_c}$ - pF | 1.00 | 0.50 | 0.25 |
| $C_{EFF\_p}$ - pF | 1.00 | 0.50 | 0.25 |
| $L_{TOT}$ - nH | 1.94 | 3.88 | 7.74 |

The above example illustrates that effective control of the reconfigurable Doherty power amplifier 300 to transition to a backoff power state that is about 6 dB below the full power state includes simultaneously:

- reconfiguring the variable output impedance transformer 380 to increase (e.g., quadruple) the combining node impedance;
- reconfiguring the first and third variable networks 334, 354 to decrease (e.g., quarter) the effective capacitances, $C_{EFF}$, at the outputs 332, 352 of the power amplifiers 331, 351; and
- reconfiguring the second variable network 340 to increase (e.g., quadruple) the total inductance, $L_{TOT}$, of the second variable network 340.

It should be noted here that, for the alternate embodiments of Doherty power amplifiers 400, 500 shown in FIGs 4 and 5, similar relative control of the values of $C_{EFF}$ and $Z_{TOT}$ (FIG. 4) or $C_{EFF}$ and $L_{TOT}$ (FIG. 5) would apply.

A special case for the embodiment of Doherty power amplifier 400 (FIG. 4) will now be discussed. As mentioned previously, it may be desirable to implement the second variable network 440 of amplifier 400 with TL segments 441-443 that are characterized by the same electrical length as each other. In addition, it may be desirable to reconfigure the output circuit 460 of the amplifier 400 in a manner in which the TL segments 441-443 may be characterized by the same electrical length, regardless of the amplifier state.

An additional example implementation will now be discussed of an asymmetric (2:1 peaking-to-carrier ratio) reconfigurable Doherty power amplifier (e.g., amplifier 400, FIG. 4) that may be selectively configured into any of three amplifier states (i.e., $N$ = 3), and that includes a second variable network 440 with TL segments 441-443 that may have a fixed electrical length, regardless of the amplifier state. In the example implementation, TL segment 441 is characterized by a first impedance, $Z_{441}$, and a first electrical length, $\beta_{441/442/443}$, TL segment 442 is characterized by a different second impedance, $Z_{442}$, and the same first electrical length, $\beta_{441/442/443}$, and TL segment 443 is characterized by a different third impedance, $Z_{443}$, and the same first electrical length, $\beta_{441/442/443}$.

In such an example embodiment, the reconfigurable Doherty power amplifier 400 may be characterized by the following parameters in a full power state (state 1), in a first backoff power state (state 2) at 3 dB below the full power state, and in a second backoff power state (state 3) at 6 dB below the full power state:

Table 9 - Implementation of asymmetric Doherty power amplifier 400 with N=3 amplifier states

| PARAMETER - UNIT | FULL POWER (STATE 1) | FIRST BACKOFF POWER (STATE 2) | SECOND BACKOFF POWER (STATE 3) |
|---|---|---|---|
| $P_{carrier}$ - W | 21.03 | 10.54 | 5.28 |
| $P_{peaking}$ - W | 42.06 | 21.08 | 10.56 |
| $R_o$ - Ohms | 14.65 | 29.23 | 58.32 |
| $C_{EFF\_c}$ - pF | 4.00 | 2.00 | 1.00 |
| $C_{EFF\_p}$ - pF | 4.00 | 2.00 | 1.00 |
| $Z_{TOT}$ - Ohms | 47.9 | 95.54 | 190.54 |
| $\beta_{441/442/443}$ - degrees | 66.6 | 66.6 | 66.6 |

Once again, the above example illustrates that effective control of the reconfigurable Doherty power amplifier 400 to transition to a backoff power state that is about 6 dB below the full power state includes simultaneously:

- reconfiguring the variable output impedance transformer 380 to increase (e.g., quadruple) the combining node impedance;
- reconfiguring the first and third variable networks 334, 354 to decrease (e.g., quarter) the effective capacitances, $C_{EFF}$, at the outputs 332, 352 of the power amplifiers 331, 351; and
- reconfiguring the second variable network 440 to increase (e.g., quadruple) the total impedance, $Z_{TOT}$, of the second variable network 440.

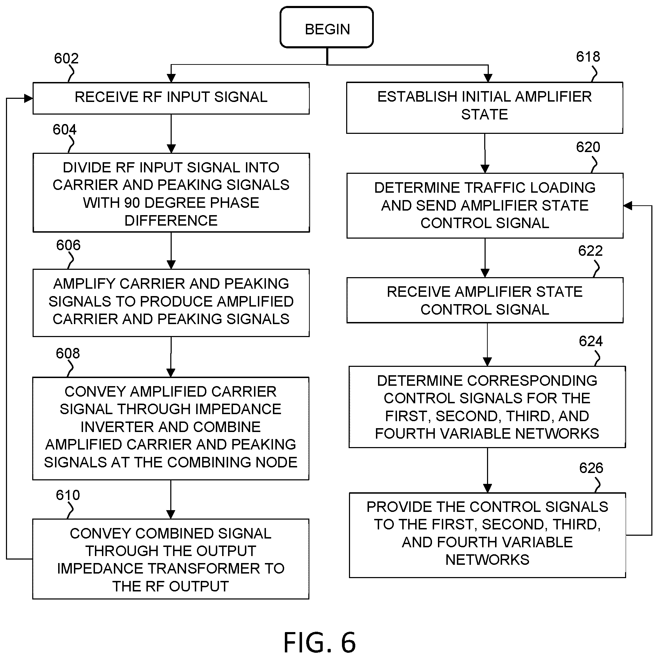

FIG. 6 is a flowchart of a method of operating a reconfigurable Doherty power amplifier (e.g., amplifiers 300, 400, 500, FIGs 3-5), in accordance with an example embodiment. According to one or more embodiments, the method includes two parallel processes, including the processes performed by the Doherty power amplifier (e.g., amplifiers 112, 300, 400, 500, FIGs 1, 3-5) and the processes performed by the base station controller and the amplifier controller (e.g., controllers 103, 114, FIGs 1, 3-5). These parallel processes may be performed simultaneously (e.g., the RF signal is continuously amplified while reconfigurations of the variable networks are performed). Alternatively, reconfiguration of the variable networks could be performed while amplification of the RF signal is not occurring (e.g., prior to amplification or during a pause in amplification).

The processes performed by the Doherty power amplifier (e.g., amplifiers 112, 300, 400, 500, FIGs 1,3-5) will be summarized first. According to one or more embodiments, the method starts at block 602, which includes receiving (e.g., at RF input 108 and power splitter input 322) an input RF signal. For example, the input RF signal may be characterized by a fundamental frequency of operation, $f_0$. In block 604, the input RF signal is divided (e.g., by power splitter 320) into a carrier input RF signal and a peaking input RF signal. The carrier input RF signal is provided (e.g., through splitter output 324) to the input of the carrier amplifier (e.g., amplifier 331), and the peaking RF signal is provided (e.g., through splitter output 326) to the input of the peaking amplifier 351. One or more phase delays may be applied so that the carrier and peaking input RF signals are about 90 degrees out of phase with respect to each other at the carrier and peaking amplifier inputs. In block 606, the carrier input RF signal is amplified through the carrier amplifier (e.g., amplifier 331), and the peaking input RF signal is amplified through the peaking amplifier (e.g., amplifier 351).

According to one or more embodiments, in block 608, the amplified carrier RF signal is conveyed through the reconfigurable impedance inverter (e.g., through variable network 334 and variable network 340, 440, 540) to the combining node (e.g., combining node 370). Simultaneously, the amplified peaking RF signal is conveyed (e.g., through variable network 354) to the combining node (e.g., combining node 370), and the amplified carrier and peaking RF signals are combined at the combining node 370. Finally, in block 610, and according to one or more embodiments, the amplified combined RF output signal is conveyed from the combining node through the variable output impedance transformer (e.g., variable output impedance transformer 380) to the RF output (e.g., RF output 110).

Simultaneously with the above-described amplification process performed by the Doherty amplifier, various traffic loading assessment and amplifier control processes are performed in order to reconfigure the Doherty power amplifier into any one of a plurality of amplifier states. According to one or more embodiments, prior to reconfiguring the Doherty power amplifier, an initial amplifier configuration is established in block 618. The initial amplifier configuration may be predetermined, in some embodiments, to correspond to any amplifier state (e.g., to the full power state, or to another state). Establishing the initial amplifier configuration may involve the base station controller sending an amplifier state control signal to the Doherty power amplifier (or more specifically to an amplifier controller, such as controller 114), and in response, the Doherty power amplifier determining and providing control signals for the reconfigurable output circuit (e.g., circuit 360, 460, 560, FIGs 3-5) that corresponds with the initial amplifier state.

After establishing the initial amplifier state, the measurement and control processes include block 620, in which the base station controller (or another subsystem) determines the current traffic loading condition for the communication system. As discussed previously, the traffic loading can be determined based on measurements or determinations of the instantaneous traffic loading of the system, which are compared to one or more thresholds (see, e.g., Table 1, above). Alternatively, the traffic loading can be estimated based on temporal factors (e.g., time-of-day, day-of week, etc.) (see, e.g., Table 2, above). Either way, the base station controller may determine, based on the measured or expected current traffic loading, a desired amplifier state as one of N possible amplifier states (e.g., full power, first backoff power, second backoff power, and so on). Upon determining the desired amplifier state, the base station controller generates and sends an amplifier state control signal to the Doherty power amplifier (or more specifically to an amplifier controller, such as controller 114). The amplifier state control signal may indicate at least one of the traffic loading condition, the power level (e.g., full power, first backoff power, etc.), or an amplifier state (e.g., state 1, state 2, etc.).

According to one or more embodiments, in block 622, the amplifier controller (e.g., amplifier controller 114) receives the amplifier state control signal from the base station controller. In block 624, the amplifier controller then determines control signals for the reconfigurable output circuit (e.g., circuit 360, 460, 560, FIGs 3-5) that correspond with the desired amplifier state. As discussed previously, each reconfigurable output circuit includes a combining node (e.g., combining node 370, FIGs 3-5), reconfigurable carrier output circuits (e.g., circuits 334, 340, 440, 540, FIGs 3-5) coupled between the carrier amplifier intrinsic drain terminal and the combining node, a reconfigurable peaking output circuit (e.g.,

circuit 354, FIGs 3-5) coupled between the peaking amplifier intrinsic drain terminal and the combining node, and a reconfigurable output impedance transformer (e.g., transformer 380, FIGs 3-5) coupled between the combining node and the amplifier output terminal (e.g., RF output 110, FIGs 3-5). The control signals produced by the amplifier controller may include first, second, third, and fourth control signals that cause the variable networks (e.g., networks 334, 340, 354, 440, 540, respectively) to be reconfigured in order to achieve the desired amplifier state. For example, the control signals may include switch control signals (e.g., for changing the states of switching elements 335, 336, 345-348, 355, 356, 545, 546) and variable component control signals (e.g., for changing the capacitance values of capacitance circuits 383, 384). The amplifier controller may determine the specific control signals, for example, using one or more lookup tables that correlate values for the control signals with switch states (for the switching elements 335, 336, 345-348, 355, 356, 545, 546) or variable component states (for the variable capacitors 383, 384) (see, e.g., Tables 3-6, above). Other suitable control circuits alternatively may be utilized. Once the control signals are determined, then in block 626, the amplifier controller provides the control signals to the first, second, third, and fourth variable networks. According to one or more embodiments, the first, second, third, and fourth variable networks are reconfigured in a synchronous manner with each other to establish each amplifier state. The amplification and network control processes are continuously repeated throughout operation of the Doherty power amplifier.

An embodiment of a Doherty power amplifier includes first and second amplifiers (e.g., carrier and peaking amplifiers, or peaking and carrier amplifiers, respectively), a reconfigurable impedance inverter, and an output impedance transformer. The first amplifier has a first amplifier output, and the first amplifier is configured to produce an amplified first output signal. The first amplifier output is characterized by a first amplifier output capacitance. The second amplifier has a second amplifier output, and the second amplifier is configured to produce an amplified second output signal. The second amplifier output is characterized by a second amplifier output capacitance. The reconfigurable impedance inverter circuit includes a combining node and first, second, and third variable networks. The combining node is configured to combine the amplified first output signal with the amplified second output signal, and the combining node is characterized by a combining node impedance. The first variable network is coupled to the first amplifier output, and the first variable network and the first amplifier output capacitance establish a first amplifier effective output capacitance that is less than the first amplifier output capacitance. The second variable network is coupled between the first amplifier output and the combining node, and the second variable network is configured to provide a series inductance between the first amplifier output and the combining node. The third variable network is coupled to the second amplifier output and to the combining node, and the third variable network and the second amplifier output capacitance establish a second amplifier effective output capacitance that is less than the second amplifier output capacitance. The output impedance transformer is coupled between the combining node and an output of the Doherty power amplifier, and the output impedance transformer includes a fourth variable network configured to establish the combining node impedance.

According to one or more further embodiments, the first variable network includes a first reconfigurable shunt inductance network coupled between the first amplifier output and a ground reference node, and the third variable network includes a second reconfigurable shunt inductance network coupled between the second amplifier output and the ground reference node. According to one or more further embodiments the second variable network includes a first inductor coupled between the first amplifier output and the combining node, and a first reconfigurable parallel inductance leg coupled in parallel with the first inductor, where the first reconfigurable parallel inductance leg includes a second inductor and a first switching element coupled in series between the first amplifier output and the combining node. According to one or more other further embodiments, the fourth variable network includes a phase shift element with a first end coupled to the combining node, and a second end coupled to the output of the Doherty power amplifier, a first variable capacitance circuit coupled between the first end of the phase shift element and a ground reference node, and a second variable capacitance circuit coupled between the second end of the phase shift element and the ground reference node.

According to one or more further embodiments, the Doherty power amplifier also includes an amplifier controller coupled to the first, second, third, and fourth variable networks. The amplifier controller is configured to receive a signal indicative of a full power state, and in response, to provide first control signals to the first, second, third, and fourth variable networks to establish the Doherty power amplifier into a first amplifier state in which the first amplifier effective output capacitance has a first capacitance value, the second amplifier effective output capacitance has a second capacitance value, the series inductance has a first inductance value, and the combining node impedance has a first impedance value. In addition, the amplifier controller is configured to receive a signal indicative of a first backoff power state, and in response, to provide second control signals to the first, second, third, and fourth variable networks to establish the Doherty power amplifier into a second amplifier state in which the first amplifier effective output capacitance has a third capacitance value that is less than the first capacitance value, the second amplifier effective output capacitance has a fourth capacitance value that is less than the second capacitance value, the series inductance has a second inductance value that is greater than the first inductance value, and the combining node impedance has a second impedance value that is greater than the first impedance value.

An embodiment of a method of operating a Doherty power amplifier includes producing, by a first amplifier, an amplified first output signal at a first amplifier output that is characterized by a first amplifier output capacitance, and producing, by a second amplifier, an amplified second output signal at a second amplifier output that is characterized by a second amplifier output capacitance. The method further includes conveying the amplified first output signal to a combining node through a first variable network and through a second variable network, where the first variable network is coupled to the first amplifier output, the first variable network and the first amplifier output capacitance establish a first amplifier effective output capacitance that is less than the first amplifier output capacitance, and the second variable network is configured to provide a series inductance between the first amplifier output and the combining node. The method further includes conveying the amplified second output signal through a third variable network to the combining node, where the third variable network is coupled to the second amplifier output, and the third variable network and the second amplifier output capacitance establish a second amplifier effective output capacitance that is less than the second amplifier output capacitance. The method further includes combining the first and second amplified output signals at the combining node to produce an amplified combined output signal, where the combining node is characterized by a combining node impedance. The method further includes conveying the amplified combined output signal through an output impedance transformer coupled between the combining node and an output of the Doherty power amplifier, where the output impedance transformer includes a fourth variable network configured to establish the combining node impedance.

According to one or more further embodiments, the method of reconfiguring the Doherty power amplifier includes reconfiguring the first variable network to modify the first amplifier effective output capacitance, simultaneously with reconfiguring the first variable network, reconfiguring the second variable network to modify the series inductance between the first amplifier output and the combining node, simultaneously with reconfiguring the first variable network, reconfiguring the third variable network to modify the second amplifier effective output capacitance, and simultaneously with reconfiguring the first variable network, reconfiguring the fourth variable network to modify the combining node impedance.

According to one or more further embodiments, the method includes reconfiguring the first variable network to modify the first amplifier effective output capacitance includes providing, by an amplifier controller, first switch control signals to the first variable network that cause at least one first switching element in the first variable network to change states, reconfiguring the second variable network to modify the series inductance between the first amplifier output and the combining node includes providing, by the amplifier controller, second switch control signals to the second variable network that cause at least one second switching element in the second variable network to change states, and reconfiguring the third variable network to modify the second amplifier effective output capacitance includes providing, by the amplifier controller, third switch control signals to the third variable network that cause at least one third switching element in the third variable network to change states.

According to one or more further embodiments, the method includes receiving an amplifier state control signal that indicates at least one of a traffic loading condition, a power level, or an amplifier state, and determining, by the amplifier controller, the first, second, and third switch control signals from a lookup table that correlates values for the amplifier state control signal with states for the at least one first switching element, the at least one second switching element, and the at least one third switching element.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

As used herein, a "node" means any internal or external reference point, connection point, junction, signal line, conductive element, or the like, at which a given signal, logic level, voltage, data pattern, current, or quantity is present. Furthermore, two or more nodes may be realized by one physical element (and two or more signals can be multiplexed, modulated, or otherwise distinguished even though received or output at a common node).

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

As used herein, the words "exemplary" and "example" mean "serving as an example, instance, or illustration." Any implementation described herein as exemplary or an example is not necessarily to be construed as preferred or advantageous over other implementations. Furthermore, there is no intention to be bound by any expressed or implied theory presented in the preceding technical field, background, or detailed description.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

**Claims**

1. A Doherty power amplifier comprising:

   a first amplifier with a first amplifier output, wherein the first amplifier is configured to produce an amplified first output signal, and the first amplifier output is **characterized by** a first amplifier output capacitance;
   a second amplifier with a second amplifier output, wherein the second amplifier is configured to produce an amplified second output signal, and the second amplifier output is **characterized by** a second amplifier output capacitance;
   a reconfigurable impedance inverter circuit that includes

      a combining node configured to combine the amplified first output signal with the amplified second output signal, wherein the combining node is **characterized by** a combining node impedance,
      a first variable network coupled to the first amplifier output, wherein the first variable network and the first amplifier output capacitance establish a first amplifier effective output capacitance that is less than the first amplifier output capacitance,
      a second variable network coupled between the first amplifier output and the combining node, wherein the second variable network is configured to provide a series inductance between the first amplifier output and the combining node, and
      a third variable network coupled to the second amplifier output and to the combining node, wherein the third variable network and the second amplifier output capacitance establish a second amplifier effective output capacitance that is less than the second amplifier output capacitance; and

   an output impedance transformer coupled between the combining node and an output of the Doherty power amplifier, wherein the output impedance transformer includes a fourth variable network configured to establish the combining node impedance.

2. The Doherty power amplifier of claim 1, wherein

   the first amplifier includes a first power transistor with a first drain terminal and a first source terminal, wherein the first drain terminal corresponds to the first amplifier output;
   the first amplifier output capacitance is a first drain-source capacitance between the first drain terminal and the first source terminal;
   the second amplifier includes a second power transistor with a second drain terminal and a second source terminal, wherein the second drain terminal corresponds to the second amplifier output; and
   the second amplifier output capacitance is a second drain-source capacitance between the second drain terminal and the second source terminal.

3. The Doherty power amplifier of claim 1 or 2, wherein:

   the first variable network includes a first reconfigurable shunt inductance network coupled between the first amplifier output and a ground reference node; and
   the third variable network includes a second reconfigurable shunt inductance network coupled between the second amplifier output and the ground reference node.

4. The Doherty power amplifier of any preceding claim, wherein:

   the first variable network includes a number, M, of first reconfigurable shunt inductance legs, where M is an integer that is equal to or greater than 1, and a first shunt inductance leg of the first reconfigurable shunt inductance legs includes a first inductor coupled in series with a first switching element; and

the third variable network includes the number, M, of second reconfigurable shunt inductance legs, and a first shunt inductance leg of the second reconfigurable shunt inductance legs includes a second inductor coupled in series with a second switching element.

5. The Doherty power amplifier of claim 4, wherein:

the first variable network also includes a second shunt inductance leg with a third inductor coupled in series with a third switching element; and
the third variable network also includes a second shunt inductance leg with a fourth inductor coupled in series with a fourth switching element.

6. The Doherty power amplifier of any preceding claim, wherein the second variable network comprises:

a first inductor coupled between the first amplifier output and the combining node; and
a first reconfigurable parallel inductance leg coupled in parallel with the first inductor, wherein the first reconfigurable parallel inductance leg includes a second inductor and a first switching element coupled in series between the first amplifier output and the combining node.

7. The Doherty power amplifier of claim 6, wherein the second variable network further comprises:
a second reconfigurable parallel inductance leg coupled in parallel with the first inductor, wherein the second reconfigurable parallel inductance leg includes a third inductor and a second switching element coupled in series between the first amplifier output and the combining node.

8. The Doherty power amplifier of any preceding claim, wherein the second variable network comprises:

a first transmission line segment coupled between the intermediate node and the combining node; and
a first reconfigurable parallel transmission line leg coupled in parallel with the first transmission line segment, wherein the first reconfigurable parallel transmission line leg includes a second transmission line segment and a first switching element coupled in series between the first amplifier output and the combining node.

9. The Doherty power amplifier of claim 8, wherein the second variable network further comprises:
a second reconfigurable parallel transmission line leg coupled in parallel with the first transmission line segment, wherein the second reconfigurable parallel transmission line leg includes a third transmission line segment and a second switching element coupled in series between the first amplifier output and the combining node.

10. The Doherty power amplifier of claim 9, wherein:

the first transmission line segment is **characterized by** a first electrical length and a first characteristic impedance;
the second transmission line segment is **characterized by** the first electrical length; and
the third transmission line segment is **characterized by** the first electrical length.

11. The Doherty power amplifier of any preceding claim, wherein the second variable network comprises:

a first inductor coupled between the first amplifier output and the combining node;
a second inductor coupled in series with the first inductor between the first amplifier output and the combining node; and
a first bypass switch coupled across the second inductor.

12. The Doherty power amplifier of claim 11, wherein the second variable network further comprises:

a third inductor coupled in series with the first and second inductors; and
a second bypass switch coupled across the third inductor.

13. The Doherty power amplifier of any preceding claim, wherein the fourth variable network comprises:

a phase shift element with a first end coupled to the combining node, and a second end coupled to the output of the Doherty power amplifier;

a first variable capacitance circuit coupled between the first end of the phase shift element and a ground reference node; and

a second variable capacitance circuit coupled between the second end of the phase shift element and the ground reference node.

14. The Doherty power amplifier of any preceding claim, further comprising:

an amplifier controller coupled to the first, second, third, and fourth variable networks, wherein,

the amplifier controller is configured to receive a signal indicative of a full power state, and in response, to provide first control signals to the first, second, third, and fourth variable networks to establish the Doherty power amplifier into a first amplifier state in which the first amplifier effective output capacitance has a first capacitance value, the second amplifier effective output capacitance has a second capacitance value, the series inductance has a first inductance value, and the combining node impedance has a first impedance value, and

the amplifier controller is configured to receive a signal indicative of a first backoff power state, and in response, to provide second control signals to the first, second, third, and fourth variable networks to establish the Doherty power amplifier into a second amplifier state in which the first amplifier effective output capacitance has a third capacitance value that is less than the first capacitance value, the second amplifier effective output capacitance has a fourth capacitance value that is less than the second capacitance value, the series inductance has a second inductance value that is greater than the first inductance value, and the combining node impedance has a second impedance value that is greater than the first impedance value.

15. A method of operating a Doherty power amplifier comprising:

producing, by a first amplifier, an amplified first output signal at a first amplifier output that is **characterized by** a first amplifier output capacitance;

producing, by a second amplifier, an amplified second output signal at a second amplifier output that is **characterized by** a second amplifier output capacitance;

conveying the amplified first output signal to a combining node through a first variable network and through a second variable network, wherein

the first variable network is coupled to the first amplifier output,

the first variable network and the first amplifier output capacitance establish a first amplifier effective output capacitance that is less than the first amplifier output capacitance, and

the second variable network is configured to provide a series inductance between the first amplifier output and the combining node;

conveying the amplified second output signal through a third variable network to the combining node, wherein

the third variable network is coupled to the second amplifier output, and

the third variable network and the second amplifier output capacitance establish a second amplifier effective output capacitance that is less than the second amplifier output capacitance;

combining the first and second amplified output signals at the combining node to produce an amplified combined output signal, wherein the combining node is **characterized by** a combining node impedance; and

conveying the amplified combined output signal through an output impedance transformer coupled between the combining node and an output of the Doherty power amplifier, wherein the output impedance transformer includes a fourth variable network configured to establish the combining node impedance.

FIG. 1

FIG. 2

FIG. 3

FIG. 4

FIG. 5

BEGIN

602
RECEIVE RF INPUT SIGNAL

604
DIVIDE RF INPUT SIGNAL INTO CARRIER AND PEAKING SIGNALS WITH 90 DEGREE PHASE DIFFERENCE

606
AMPLIFY CARRIER AND PEAKING SIGNALS TO PRODUCE AMPLIFIED CARRIER AND PEAKING SIGNALS

608
CONVEY AMPLIFIED CARRIER SIGNAL THROUGH IMPEDANCE INVERTER AND COMBINE AMPLIFIED CARRIER AND PEAKING SIGNALS AT THE COMBINING NODE

610
CONVEY COMBINED SIGNAL THROUGH THE OUTPUT IMPEDANCE TRANSFORMER TO THE RF OUTPUT

618
ESTABLISH INITIAL AMPLIFIER STATE

620
DETERMINE TRAFFIC LOADING AND SEND AMPLIFIER STATE CONTROL SIGNAL

622
RECEIVE AMPLIFIER STATE CONTROL SIGNAL

624
DETERMINE CORRESPONDING CONTROL SIGNALS FOR THE FIRST, SECOND, THIRD, AND FOURTH VARIABLE NETWORKS

626
PROVIDE THE CONTROL SIGNALS TO THE FIRST, SECOND, THIRD, AND FOURTH VARIABLE NETWORKS

FIG. 6

Europäisches
Patentamt

European
Patent Office

Office européen
des brevets

# EUROPEAN SEARCH REPORT

**Application Number**

EP 25 17 5495

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/092074 A1 (YANDURU NAVEEN [US] ET AL) 19 April 2012 (2012-04-19) | 1-13,15 | INV. H03F1/02 H03F1/56 H03F3/195 H03F3/24 |
| A | * paragraphs [0003] - [0055]; figures 1-6 * ----- | 14 | |
| A | US 10 903 182 B1 (WANG LU [US] ET AL) 26 January 2021 (2021-01-26) * column 1, line 8 - column 54, line 12; figures 1-15B * ----- | 1-15 | |
| A | US 2017/302236 A1 (OSHITA TERUAKI [JP]) 19 October 2017 (2017-10-19) * paragraphs [0002] - [0241]; figures 1-20B * ----- | 1-15 | |
| A | US 2015/130541 A1 (LIAO ZHONGYU [CN] ET AL) 14 May 2015 (2015-05-14) * paragraphs [0002] - [0113]; figures 1-11 * ----- | 1-15 | |
| | | | TECHNICAL FIELDS SEARCHED (IPC) H03F |

The present search report has been drawn up for all claims

| Place of search | Date of completion of the search | Examiner |
|---|---|---|
| The Hague | 30 September 2025 | Fedi, Giulio |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 17 5495

This annex lists the patent family members relating to the patent documents cited in the above-mentioned European search report.
The members are as contained in the European Patent Office EDP file on
The European Patent Office is in no way liable for these particulars which are merely given for the purpose of information.

30-09-2025

| Patent document cited in search report | | | Publication date | Patent family member(s) | | Publication date |
|---|---|---|---|---|---|---|
| US 2012092074 | A1 | | 19-04-2012 | NONE | | |
| US 10903182 | B1 | | 26-01-2021 | NONE | | |
| US 2017302236 | A1 | | 19-10-2017 | NONE | | |
| US 2015130541 | A1 | | 14-05-2015 | CN | 104604125 A | 06-05-2015 |
| | | | | EP | 2865095 A1 | 29-04-2015 |
| | | | | US | 2015130541 A1 | 14-05-2015 |
| | | | | WO | 2013188994 A1 | 27-12-2013 |

For more details about this annex : see Official Journal of the European Patent Office, No. 12/82